# EUROPEAN PATENT SPECIFICATION

(11) **EP 4 266 654 B1**
(45) Date of publication and mention of the grant of the patent: **11.02.2026**
(21) Application number: 23712448.2
(22) Date of filing: 02.03.2023
(51) Int. Cl.: H04M 1/02, G06F 1/16

(54) **SLIDABLE ELECTRONIC DEVICE CONSIDERING COMPONENT PLACEMENT SPACE**
VERSCHIEBBARE ELEKTRONISCHE VORRICHTUNG UNTER BERÜCKSICHTIGUNG DES BEREICHS ZUR PLATZIERUNG
DISPOSITIF ÉLECTRONIQUE COULISSANT PRENANT EN COMPTE UN ESPACE DE PLACEMENT DE COMPOSANT

(30) Priority: 11.03.2022 KR 20220030999; 25.07.2022 KR 20220091933
(43) Date of publication of application: 25.10.2023
(73) Proprietor: Samsung Electronics Co., Ltd., Suwon-si, Gyeonggi-do 16677 (KR)
(72) Inventor: LEE, Wonho, Suwon-si, Gyeonggi-do 16677 (KR); KIM, Hyunsuk, Suwon-si, Gyeonggi-do 16677 (KR); PARK, Sanghyuk, Suwon-si, Gyeonggi-do 16677 (KR); SEO, Soohyun, Suwon-si, Gyeonggi-do 16677 (KR); CHO, Joongyeon, Suwon-si, Gyeonggi-do 16677 (KR); CHOI, Nakhyun, Suwon-si, Gyeonggi-do 16677 (KR); LEE, Junghyeob, Suwon-si, Gyeonggi-do 16677 (KR); HONG, Hyunju, Suwon-si, Gyeonggi-do 16677 (KR)
(74) Representative: Nederlandsch Octrooibureau
(86) International application number: PCT/KR2023/002864
(87) International publication number: WO 2023/171979

(56) References cited:
- WO-A1-2022/050581
- KR-A- 20190 050 171
- KR-A- 20220 008 715
- KR-A- 20220 029 148
- KR-B1- 101 832 774
- US-A1- 2021 240 294
- US-A1- 2022 026 954

## Description

### [Technical Field]

Various embodiments disclosed in this document relate to a slidable electronic device in consideration of a space for placement of components.

### [Background Art]

As a deformable display is developed, new types of electronic devices other than an existing bar type electronic device are being introduced.

A slidable electronic device may indicate a new type of electronic device that includes a slidable housing so that a display area of a display is expanded or reduced according to sliding of the housing.

Known devices including a sliding housing and a rollable display are disclosed by prior art patent applications US 2022/026954 A1 and US 2021/240294 A1.

### [Disclosure of Invention]

### [Technical Problem]

An electronic device may include electronic components for executing various functions and a battery for driving the electronic components.

In the case of a slidable electronic device, an internal space of the electronic device may be expanded or reduced according to sliding of the housing. Various components included in the electronic device may need to be placed inside the electronic device when the slidable electronic device is in a slid-in state.

The slidable electronic device has a problem in which the internal space for placing the electronic components is reduced because components for sliding operation are added and because electronic components or structures thereof overlap each other in the slide-in state.

Various embodiments disclosed in this document may provide a slidable electronic device having a structure capable of securing a space in which electronic components such as a battery may be placed.

### [Technical Solution]

An electronic device as defined in independent claim 1 comprises a first housing; a second housing coupled to the first housing so as to slide in a first direction and in a second direction opposite the first direction; a printed circuit board disposed in the second housing; a rear cover disposed in the second housing and configured to support the printed circuit board; a rollable display comprising a display area exposed to the outside of the electronic device, an accommodation area accommodated inside the electronic device, and a bending area connecting the display area and the accommodation area and configured to be bent, and wherein the display area is reduced or expanded based on a sliding-in or sliding-out operation of the second housing; a driving motor disposed in the first housing and configured to drive the second housing to slide in or slide out; and a battery disposed in a space provided in the first housing and the second housing, wherein the rear cover is formed so as not to overlap the accommodation area of the rollable display when the rollable display is viewed vertically and when the second housing is in a full slide-in state in the second direction.

Further advantageous features are defined in dependent claims 2 to 15.

### [Advantageous Effects of Invention]

According to various embodiments disclosed in this document, it is possible to disposed a larger battery through a structure capable of securing an internal space of a slidable electronic device. Accordingly, the use time of the electronic device may increase.

It is possible to secure a space where a driving device capable of automatically sliding the slidable electronic device may be disposed, thereby disposing a driving device having a sufficient driving force for sliding in the electronic device.

In addition, it is possible to improve the durability of a rollable display by reducing the stress of a part where the rollable display is deformed.

### [Brief Description of Drawings]

In connection with the description of the drawings, the same or similar reference numerals may be used for the same or similar elements.
FIG. 1 is a block diagram of an electronic device 101 in a network environment 100 according to various embodiments.
FIGS. 2A and 2B are diagrams illustrating front and rear surfaces of an electronic device in a slide-in state according to various embodiments of the disclosure.
FIGS. 3A and 3B are diagrams illustrating front and rear surfaces of an electronic device in a slide-out state according to various embodiments of the disclosure.
FIG. 4 is an exploded perspective view of an electronic device according to various embodiments of the disclosure.
FIG. 5A is a diagram illustrating a placement structure of electronic components included in a support bracket according to various embodiments of the disclosure.
FIG. 5B is a diagram illustrating partial configuration of an electronic device including a guide structure according to various embodiments of the disclosure.
FIG. 6A is a cross-sectional view of an electronic device taken along line 5a-5a in FIG. 2A according to various embodiments of the disclosure.
FIG. 6B is a cross-sectional view of an electronic device taken along line 5b-5b in FIG. 3A according to various embodiments of the disclosure.
FIG. 7 is a perspective view of an electronic device according to a first embodiment disclosed in this document.
FIG. 8 is a perspective view of an electronic device according to a second embodiment disclosed in this document.
FIG. 9 is a cross-sectional view of the electronic device according to the first embodiment cut along a sliding direction.
FIG. 10 is a cross-sectional view of the electronic device according to the second embodiment cut along a sliding direction.
FIG. 11 is a cross-sectional view of the electronic device according to the first embodiment cut along a sliding direction so that a driving motor is visible.
FIG. 12 is a cross-sectional view of the electronic device according to the second embodiment cut along the sliding direction so that the driving motor is visible.

### [Mode for the Invention]

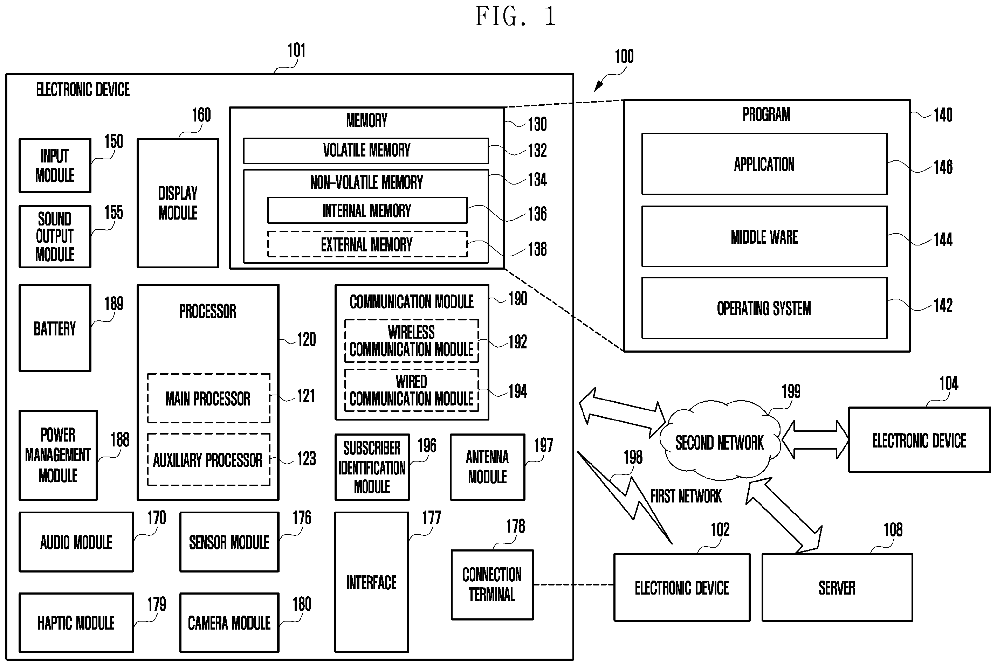

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmwave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

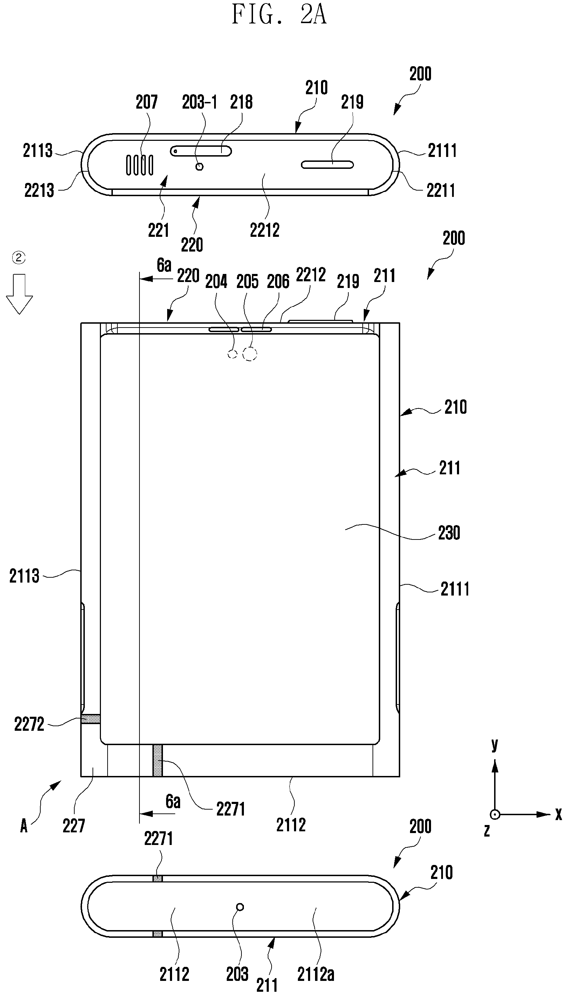

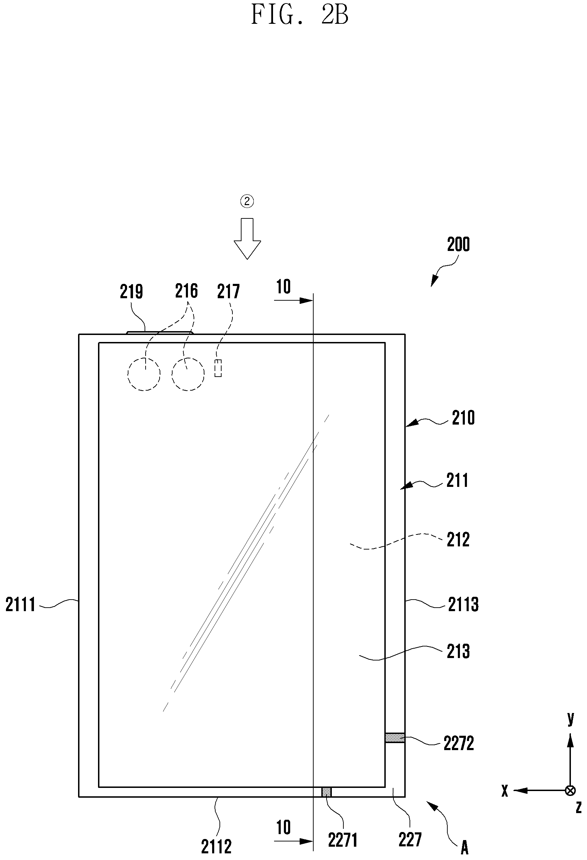

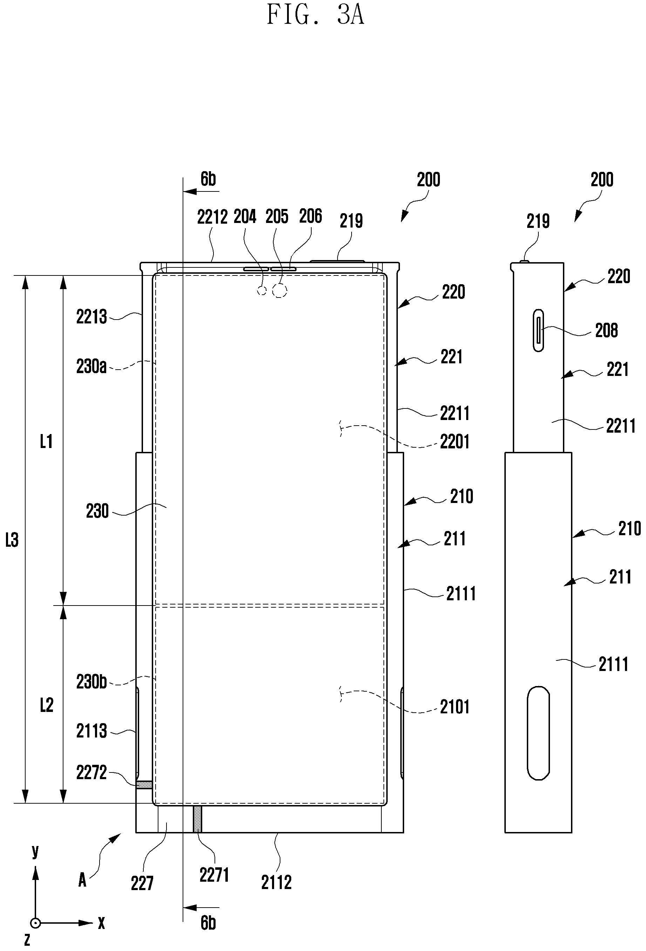

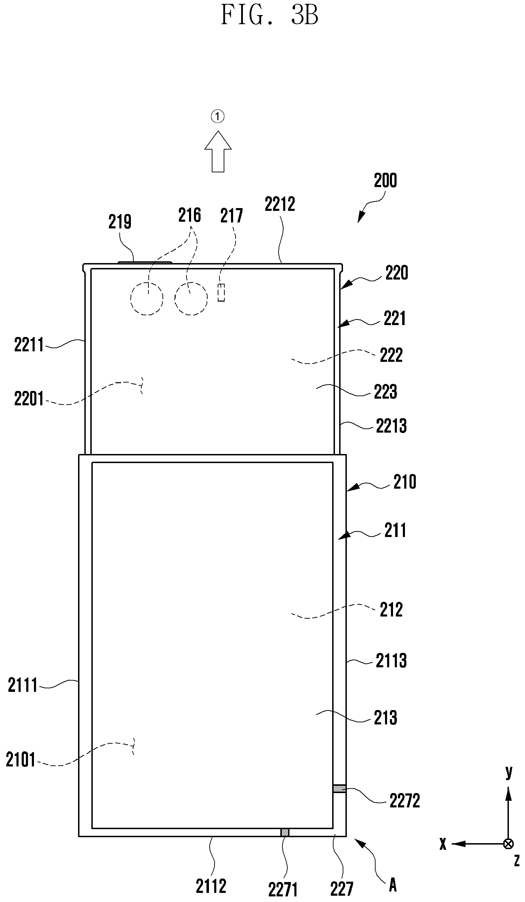

FIGS. 2A and 2B are views illustrating front and rear surfaces of an electronic device according to various embodiments of the disclosure in a slide-in state. FIGS. 3A and 3B are views illustrating front and rear surfaces of the electronic device according to various embodiments of the disclosure in a slide-out state.

The electronic device 200 of FIGS. 2A to 3B may be at least partially similar to the electronic device 101 of FIG. 1, or may further include other embodiments of the electronic device.

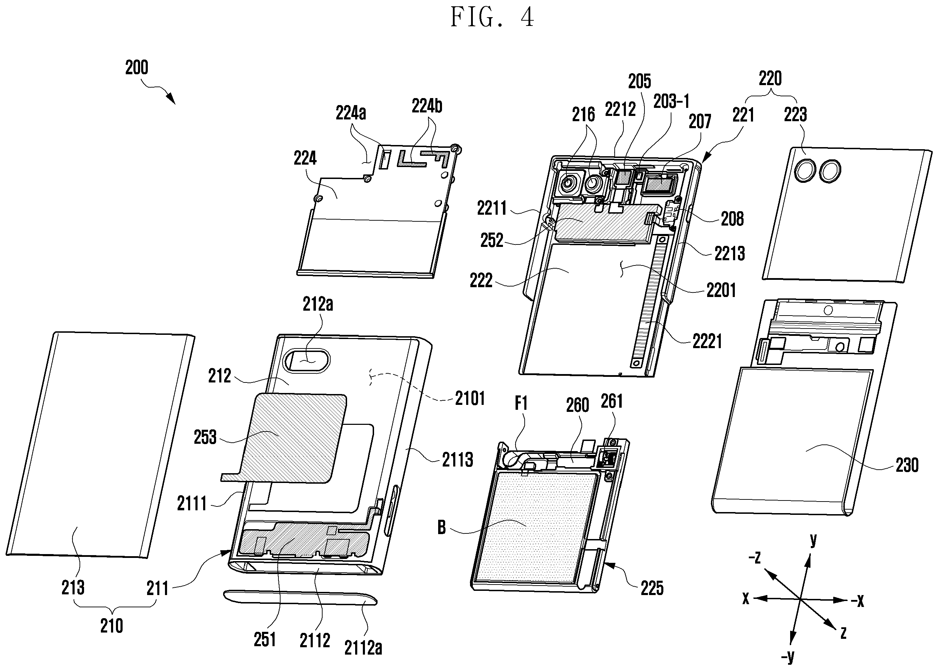

Referring to FIGS. 2A to 3B, the electronic device 200 may include: a first housing 210; a second housing 220 (e.g., a second housing structure, a fixing portion, or a base housing) coupled to be slidable in a predetermined direction (e.g., in direction ① or direction ②) (e.g., ±y-axis direction) from the first housing 210; and a rollable display 230 (e.g., a flexible display, an expandable display, or a stretchable display) disposed to be supported by at least a portion of the first and second housings 210 and 220. According to an embodiment, the electronic device 200 may be configured such that, with reference to the first housing 210 held by a user, the second housing 220 slides out in a first direction (direction ①or in a second direction (direction ②) opposite to the first direction (direction ①). According to an embodiment, at least a portion of the second housing 220 including a second space 2201 may be changed into the slide-in state by being accommodated in the first space 2101 of the first housing 210. According to an embodiment, the electronic device 200 may include a support member (e.g., the support member 240 in FIG. 4) (e.g., a bendable member, an articulated hinge module or a multi-bar assembly) configured to be at least partially coplanar with at least a portion of the second housing 220 in the slide-out state and at least partially accommodated in the first space 2101 of the first housing 210 in the slide-in state. According to an embodiment, in the slide-in state, at least a portion of the rollable display 230 may be disposed to be invisible from the outside by being accommodated into the first space 2101 of the first housing 210 in a bending manner while being supported by the support member (e.g., the support member 240 in FIG. 4). According to an embodiment, in the slide-out state, at least a portion of the rollable display 230 may be disposed to be visible from the outside while being supported by the support member (e.g., the support member 240 in FIG. 4), which is at least partially coplanar with the second housing 220.

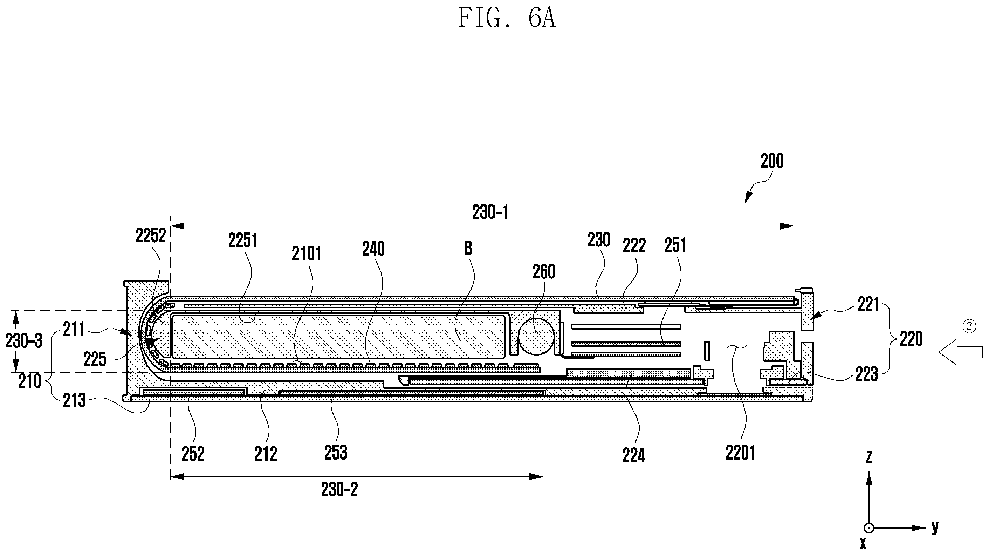

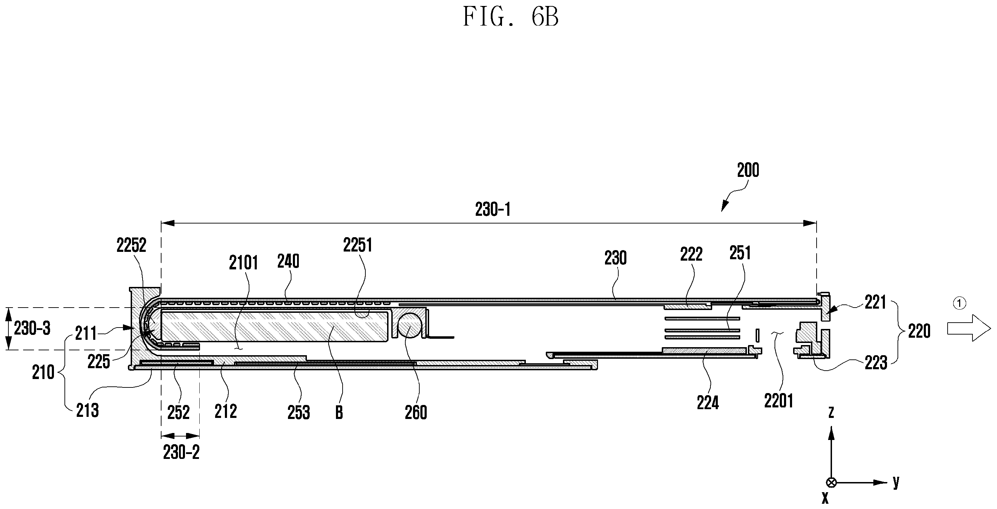

The rollable display 230 has an externally visible part (e.g., a display area (e.g., the display of FIGS. 6A and 6B) that is externally visible according to the sliding of the second housing 220 relative to the first housing 210. Area 230 - 1) that may increase or decrease in size. In addition, according to the sliding of the second housing 220 relative to the first housing 210, a portion of the rollable display 230 stored inside the electronic device 200 (eg, a accommodation area (for example: The accommodation area 230-2 of FIG. 6A) may increase or decrease in size.

According to various embodiments, the electronic device 200 may include a first housing 210 including a first side surface member 211 and a second housing 220 including a second side surface member 221. According to an embodiment, the first side surface member 211 may include: a first side surface 2111 having a first length along a first direction (e.g., the y-axis direction); a second side surface 2112 extending from the first side surface 2111 along a direction substantially perpendicular to the first side surface 2111 and having a second length shorter than the first length; and a third side surface 2113 extending from the second side surface 2111 to be substantially parallel to the first side surface 2111 and having the first length. According to an embodiment, at least a portion of the first side surface member 211 may be formed of a conductive member (e.g., a metal member). In some embodiments, the first side surface member 211 may be configured by coupling a conductive member and a non-conductive member (e.g., a polymer member). According to an embodiment, the first housing 210 may include a first extension member 212 extending from at least a portion of the first side surface member 211 to at least a portion of the first space 2101. According to an embodiment, the first extension member 212 may be configured integrally with the first side surface member 211. In some embodiments, the first extension member 212 may be configured separately from the first side surface member 211 and may be structurally coupled to the first side surface member 211.

According to various embodiments, the second side surface member 221 may include: a fourth side surface 2211 at least partially corresponding to the first side surface 2111 and having a third length; a fifth side surface 2212 extending from the fourth side surface 2211 in a direction substantially parallel to the second side surface 2112 and having a fourth length longer than the third length; and a sixth side surface 2213 extending from the fifth side surface 2212 to correspond to the third side surface 2113 and having the third length. According to an embodiment, at least a portion of the second side surface member 221 may be formed of a conductive member (e.g., a metal member). In some embodiments, the second side surface member 221 may be configured by coupling a conductive member and a non-conductive member (e.g., a polymer member). According to an embodiment, at least a portion of the second side surface member 221 may include a second extension member 222 extending to at least a portion of the second space 2201 of the second housing 220. According to an embodiment, the second extension member 222 may be configured integrally with the second side surface member 221. In some embodiments, the second extension member 222 may be configured separately from the second side surface member 221 and may be structurally coupled to the second side surface member 221.

According to various embodiments, the first side surface 2111 and the fourth side surface 2211 may be slidably coupled to each other. According to an embodiment, the third side surface 2113 and the sixth side surface 2213 may be slidably coupled to each other. According to an embodiment, in the slide-in state, the fourth side surface 2211 may be disposed to be substantially invisible from the outside by overlapping the first side surface 2111. According to an embodiment, in the slide-in state, the sixth side surface 2213 may be disposed to be substantially invisible from the outside by overlapping the third side surface 2113. In some embodiments, at least a portion of the fourth and sixth side surfaces 2211 and 2213 may be disposed to be at least partially visible from the outside in the slide-in state. According to an embodiment, in the slide-in state, the second extension member 222 may be disposed to be substantially invisible from the outside by overlapping the first extension member 212.

According to various embodiments, the first housing 210 may include a first rear surface cover 213 coupled to at least a portion of the first side surface member 211. According to an embodiment, the first rear surface cover 213 may be coupled to at least a portion of the first extension member 212. In some embodiments, the first rear surface cover 213 may be configured integrally with the first side surface member 211. According to an embodiment, the first rear surface cover 213 may be made of a polymer, coated or tinted glass, ceramic, a metal (e.g., aluminum, stainless steel (STS), or magnesium), or a combination of at least two of these materials. In some embodiments, the first rear surface cover 213 may extend to at least a portion of the first side surface member 211. In some embodiments, at least a portion of the first extension member 212 may be replaced with the first rear surface cover 213. For example, the entire first extension member 212 may be replaced with the first rear surface cover 213. In this example, the first extension member 212 is thus absent.

According to various embodiments, the second housing 220 may include a second rear surface cover 223 coupled to at least a portion of the second side surface member 221. According to an embodiment, the second rear surface cover 223 may be disposed in a manner of being coupled to at least a portion of the second extension member 222. In some embodiments, the second rear surface cover 223 may be configured integrally with the second side surface member 221. According to an embodiment, the second rear surface cover 223 may be made of a polymer, coated or tinted glass, ceramic, a metal (e.g., aluminum, stainless steel (STS), or magnesium), or a combination of at least two of these materials. In some embodiments, the second rear surface cover 223 may extend to at least a portion of the second side surface member 221. In some embodiments, at least a portion of the second extension member 222 may be replaced with the second rear surface cover 223. For example, the entire second extension member 222 may be replaced with the second rear surface cover 223. In this example, the first extension member 222 is thus absent.

According to various embodiments, the electronic device 200 may include a rollable display 230 disposed to be supported by at least a portion of the first housing 210 and at least a portion of the second housing 220. According to an embodiment, the rollable display 230 may include: a first portion 230a (e.g., a flat portion) that is always visible from the outside; and a second portion 230b (e.g., a bendable portion) extending from the first portion 230a and at least partially accommodated in the first space 2101 of the first housing 210 to be invisible from the outside in the slide-in state. According to an embodiment, the first portion 230a may be disposed to be supported by the second housing 220, and the second portion 230b may be disposed to be at least partially supported by the support member (e.g., the support member 240 in FIG. 4). According to an embodiment, in the state in which the second housing 220 is slid out along a first direction (direction ①), the second portion 230b of the rollable display 230 may extend from the first portion 230a while being supported by the support member (e.g., the support member 240 in FIG. 4), and may be disposed to be substantially coplanar with the first portion 230a and to be visible from the outside. According to an embodiment, in the state in which the second housing 220 is slid in along a second direction (direction ②), the second portion 230b of the rollable display 230 may be disposed to be accommodated into the first space 2201 of the first housing 210 in a bending manner and to be invisible from the outside. Accordingly, in the electronic device 200, the display area of the rollable display 230 may be variable, since the second housing 220 is movable in a sliding manner from the first housing 210 in a predetermined direction (e.g., y-axis direction). In particular, the display area of the rollable display 230 may be varied through sliding the second housing 220 in or out.

According to various embodiments, the rollable display 230 may be variable in length in the first direction (direction ①) according to the sliding of the second housing 220 that is moved with reference to the first housing 210. For example, in the slide-in state, the rollable display 230 may have a first display area corresponding to a first length L1 (e.g., an area corresponding to the first portion 230a). According to an embodiment, in the slide-out state, according to the sliding of the second housing 220 further moved by a second length L2 with reference to the first housing 210, the rollable display 230 may be expanded to have a third display area (e.g., an area including the first portion 230a and the second portion 230b), which corresponds to a third length L3 longer than the first length L1 and is larger than the first display area.

According to various embodiments, the electronic device 200 may include at least one component disposed in the second space 2201 of the housing 220. For example the component may be an input device (e.g., a microphone 203-1, a sound output device (e.g., a phone call receiver 206 and/or a speaker 207), sensor modules 204 and/or 217, a camera module (e.g., the first camera module 205 or the second camera module 216), a connector port 208, a key input device 219, or an indicator (not illustrated). According to an embodiment, the electronic device 200 may include another input device (e.g., the microphone 203) disposed in the first housing 210. In another embodiment, the electronic device 200 may be configured such that at least one of the above-mentioned components is omitted or other components are additionally included. In another embodiment, at least one of the above-described components may be disposed in the first space 2101 of the first housing 210. For example, additionally or alternatively, at least one component, such as a microphone, a sound output device (e.g., a phone call receiver and/or a speaker), a sensor module, a camera module, a connector port, a key input device, or an indicator may be disposed in the first space 2101 of the first housing 210.

According to various embodiments, the input device may include a microphone 203-1. In some embodiments, the input device (e.g., the microphone 203-1) may include a plurality of microphones arranged to detect the direction of sound. The sound output device may include, for example, a phone call receiver 206 and a speaker 207. According to an embodiment, regardless of the slide-in/slid-out state, the speaker 207 may correspond to the outside through at least one speaker hole provided in the second housing 220 at a position (e.g., the fifth side surface 2212) always exposed to the outside. According to an embodiment, in the slide-out state, the connector port 208 may correspond to the outside through a connector port hole provided in the second housing 220. In some embodiments, in the slide-in state, the connector port 208 may correspond to the outside through an opening provided in the first housing 210 to correspond to the connector port hole. In some embodiments, the phone call receiver 206 may include a speaker that is operated without a separate speaker hole (e.g., a piezo speaker).

According to various embodiments, the sensor modules 204 and 217 may generate electrical signals or data values corresponding to the internal operating state of the electronic device 200 or an external environmental state. The sensor modules 204 and 217 may include, for example, a first sensor module 204 (e.g., a proximity sensor or an illuminance sensor) disposed on the front surface of the electronic device 200 and/or a second sensor module 217 (e.g., a heart rate monitoring (HRM) sensor) disposed on the rear surface of the electronic device 200. According to an embodiment, the first sensor module 204 may be disposed under the rollable display 230 in the front surface of the electronic device 200. According to an embodiment, the first sensor module 204 and/or the second sensor module 217 may include at least one of a proximity sensor, an illuminance sensor, a time of flight (TOF) sensor, an ultrasonic sensor, a fingerprint recognition sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor. In particular, it is possible that multiple of the above-mentioned sensors are disposed under the rollable display 230 in the front surface of the electronic device 200. Additionally or alternatively, it is possible that multiple of the above mentioned sensors are disposed on the rear surface of the electronic device 200.

According to various embodiments, the camera module may include a first camera module 205 disposed on the front surface of the electronic device 200 and a second camera module 216 disposed on the rear surface of the electronic device 200. However, it is alternatively possible that the camera module includes only one of the first camera module 205 and the second camera module 216. According to an embodiment, the electronic device 200 may include a flash (not illustrated) located near the second camera module 216. According to an embodiment, the camera modules 205 and 216 may include one or more lenses, an image sensor, and/or an image signal processor. According to an embodiment, the first camera module 205 may be disposed under the rollable display 230 and configured to photograph a subject through a portion of an active area (e.g., a display area) of the rollable display 230.

According to various embodiments, the first camera module 205 among the camera modules and one or more sensor modules 204 among the sensor modules 204 and 217 may be disposed to detect the external environment through the rollable display 230. For example, the first camera module 205 or one or more sensor modules 204 may be disposed in the second space 2201 of the second housing 220 to be in contact with the external environment through a transmission area or a perforated opening provided in the rollable display 230. According to an embodiment, the area of the rollable display 230, which faces the first camera module 205, may be configured as a transmission area having a predetermined transmittance as a portion of display area for displaying contents. According to an embodiment, the transmission area may have a transmittance in the range of about 5% to about 20%. The transmission area may include an area overlapping the effective area (e.g., the view angle area) of the first camera module 205 through which light imaged by an image sensor to generate an image passes. For example, the transmission area of the rollable display 230 may include an area having a lower pixel arrangement density and/or wiring density than the surrounding area. For example, the transmission area may replace the above-mentioned openings. For example, some camera modules 205 may include an under-display camera (UDC). In some embodiments, one or more sensor modules 204 may be disposed to perform the functions thereof in the internal space of the electronic device 200 without being visually exposed through the rollable display 230.

According to various embodiments, the electronic device 200 may include at least one antenna element (e.g., the antenna element 214b in FIG. 4) electrically connected to a wireless communication circuit (e.g., the wireless communication module 192 in FIG. 1) disposed in the second housing 220. According to an embodiment, the electronic device 200 may include a bezel antenna A disposed through the conductive first side surface member 211 of the first housing 210. For example, the bezel antenna A may include a conductive portion 227 disposed in at least a portion of the second and third side surfaces 2112 and 2113 of the first side surface member 211 and electrically split by at least one splitting portions 2271 and 2272 made of a non-conductive material (e.g., a polymer). According to an embodiment, the wireless communication circuit (e.g., the wireless communication module 192 in FIG. 1) may be configured to transmit or receive a wireless signal in at least one predetermined frequency band (e.g., about 600 MHz to 9000 MHz) (e.g., a legacy band or NR band) via the conductive portion 227. According to an embodiment, the electronic device 200 may include a side surface cover 2112a disposed on the second side surface 2112 to cover at least a portion of the at least one splitting portion 2271. In some embodiments, the bezel antenna A may be disposed on at least one of the first side surface 2111, the second side surface 2212, and the third side surface 2113. In some embodiments, the bezel antenna A may be disposed on at least one of the fourth side surface 2211, the fifth side surface 2212, and the sixth side surface 2213 of the second housing 220. In some embodiments, the electronic device 200 may further include at least one antenna module (e.g., a 5G antenna module or an antenna structure) disposed in the internal space (e.g., the second space 2201 or the first space 2101) and configured to transmit or receive a wireless signal of a frequency band in the range of about 3 GHz to 100 GHz via another wireless communication circuit (e.g., the wireless communication module 192 in FIG. 1). In some embodiments, the wireless communication circuit may be disposed in the first housing 210.

According to various embodiments, the slide-in/slide-out operation of the electronic device 200 may be automatically performed. For example, the slide-in/slide-out operation of the electronic device 200 may be executed by a driving motor (e.g., the driving motor 260 in FIG. 4), for example via gear coupling. In particular, the driving motor may include a pinion gear (e.g., the pinion gear 261 in FIG. 4) disposed in the first space 2101 of the first housing 220 and a rack gear (e.g., the rack gear 2221 in FIG. 4) disposed in the second space 2201 of the second housing 210 and gear-coupled with the pinion gear 261. For example, when detecting a triggering operation of switching from the slide-in state to the slide-out state or from the slide-out state to the slide-in state, the processor (e.g., the processor 120 in FIG. 1) of the electronic device 200 may operate the driving motor (e.g., the driving motor 260 in FIG. 4) disposed inside the electronic device 200. According to an embodiment, the triggering operation may include selecting (e.g., touching) an object displayed on the rollable display 230 or operating a physical button (e.g., a key button) included in the electronic device 200.

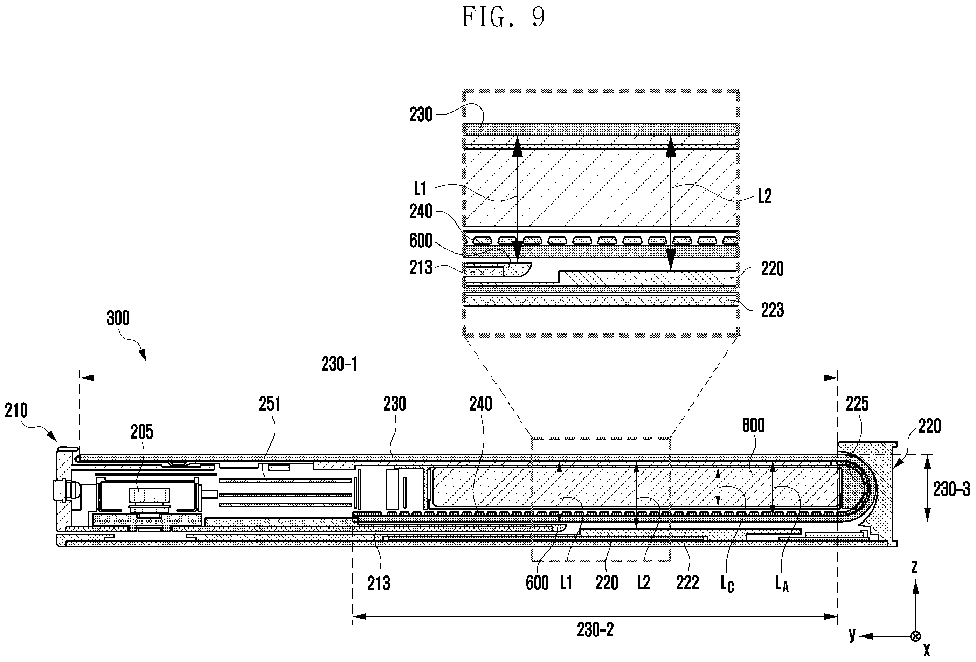

An electronic device 200 according to an exemplary embodiment of the disclosure may include a driving motor (e.g., the driving motor 260 in FIG. 4) disposed in the first space 2201 of the first housing 210 at the end closest to the second space 2101 of the second housing 220 in the slide-out direction (direction ①) and include an electrical connection structure electrically connected to a second printed circuit board (e.g., the second printed circuit board 252 in FIG. 4) disposed in the second space 2201 via a flexible printed circuit board (e.g., the flexible printed circuit board F1 in FIG. 9A), so that a length of electrical connection structures between the second printed circuit board 252 and the driving motor 260, which are disposed in different housings 210 and 220, respectively, may be minimized to help improve operational reliability. According to an embodiment, the electronic device 200 may include a battery (e.g., the battery B in FIG. 4) disposed in the first space 2101 of the first housing 210 to support at least a portion of the rollable display 230 in the slide-out state, which may help improve the operational reliability of the electronic device 200. According to an embodiment, the electronic device 200 includes the driving motor 260 and the battery B disposed in the first space 2101 of the first housing 210, which may induce a relatively light weight of the second housing 220 to minimize driving resistance. Thus, it is possible to induce sliding of the second housing 220 with minimal power consumption.

Hereinafter, a detailed description of the device illustrated in Figures 2A-3C will be made below with reference to Figures 4-12.

FIG. 4 is an exploded perspective view of an electronic device according to various embodiments of the disclosure.

In describing the electronic device 200 of FIG. 4, the same reference numerals are assigned to components that are substantially the same as those of the electronic device 200 of FIGS. 2A to 3B, and a detailed description thereof may be omitted.

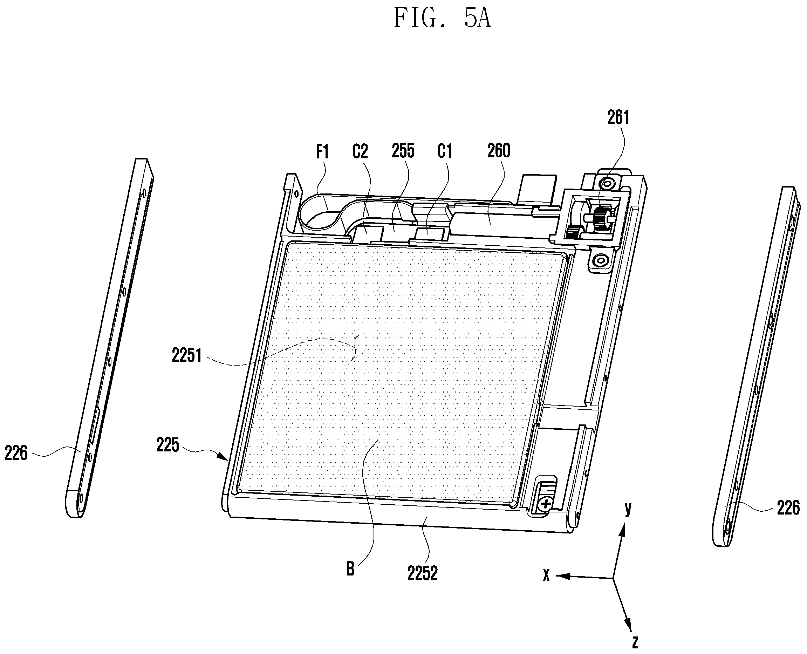

Referring to FIG. 4, the electronic device 200 may include: a first housing 210 including a first space 2101; a second housing 220 coupled to be slidable from the first housing 210 and including a second space (e.g., the second space 2201 in FIG. 3A); a support member (e.g., the support member 240 in FIG. 6B) pivotably disposed in a manner of being at least partially bendable in the second space 2201; a rollable display 230 disposed to be supported by at least a portion of the support member 240 and the second housing 220; and a driving module configured to drive the second housing 220 in a slide-in direction (e.g., the -y-axis direction) and/or a slide-out direction (e.g., the y-axis direction) relative to the first housing 210. According to an embodiment, the first housing 210 may include: a first side surface member 211; and a first rear surface cover 213 coupled with at least a portion of the first side surface member 211 (e.g., at least a portion of the first extension member 212). According to an embodiment, the second housing 220 may include: a second side surface member 221; and a second rear surface cover 223 coupled with at least a portion of the second side surface member 221 (e.g., at least a portion of the second extension member 221). According to an embodiment, the driving module may include: a driving motor 260 disposed in the first space 2101 and including a pinion gear (e.g., the pinion gear 261 in FIG. 5A); and a rack gear 2221 disposed in the second space 2201 to be gear-coupled with the pinion gear 261. According to an embodiment, the driving module may further include a reduction module including a plurality of gear assemblies arranged to reduce a rotation speed and increase a driving force by being coupled to the driving motor 260. According to an embodiment, the driving motor 260 may be disposed to be supported via at least a portion of a support bracket 225 disposed in the first space 2101 of the first housing 210. According to an embodiment, the driving motor 260 may be fixed to an end (e.g., an edge) of the support bracket 225 in the slide-out direction (e.g., the y-axis direction) in the first space 2101.

According to various embodiments, the electronic device 200 may include at least one electronic component disposed in the second space 2201. According to an embodiment, the at least one electronic component may include: a first printed circuit board 251 disposed in the first housing 210; and a second printed circuit board 252 disposed in the second housing. According to an embodiment, the at least one electronic component may include one or more of a camera module 216, a speaker 207, a connector port 208, and a microphone 203-1 arranged around the second printed circuit board 252 in the second space 2201. According to an embodiment, since the at least one electronic component is disposed around the second printed circuit board 252 in the second space 2201 of the second housing 220, efficient electrical connection may be possible.

According to various embodiments, the electronic device 200 may include a rear bracket 224 disposed to cover at least some of a plurality of electronic components disposed between the second extension member 222 and the second rear surface cover 223 in the second housing 220. According to an embodiment, the rear bracket 224 may be structurally coupled to at least a portion of the second extension member 222. In some embodiments, the rear bracket 224 may be omitted. According to an embodiment, the rear bracket 224 may be disposed to cover at least one electronic component and to support the second rear surface cover 223. According to an embodiment, the rear bracket 224 may include a notch area 224a or an opening 224a (e.g., a through hole) provided in an area corresponding to the camera module 216 and/or the sensor module (e.g., the sensor module 217 in FIG. 3B). According to an embodiment, the rear bracket 224 may include at least one antenna element 224b. According to an embodiment, when the rear bracket 224 is a dielectric injection-molded product (e.g., an antenna carrier), the at least one antenna element 224b may be disposed on the outer surface of the rear bracket 224. According to an embodiment, the at least one antenna element 224b may include a laser direct structuring (LDS) antenna pattern provided on the outer surface of the rear bracket 224. **In** some embodiments, the at least one antenna element 224b may include a conductive plate attached to the outer surface of the rear bracket 224 or a conductive paint or conductive pattern provided on the outer surface. **In** some embodiments, the at least one antenna element 224b may be disposed in a built-in manner when the rear bracket 224 is injection-molded. According to an embodiment, the at least one antenna element 224b may be configured to transmit or receive a wireless signal in a predetermined frequency band (e.g., a legacy band) by being electrically connected to a wireless communication circuit (e.g., the wireless communication module 192 in FIG. 1) disposed on the first printed circuit board 251. According to an embodiment, the camera module 216 and/or the sensor module 217 may be arranged to detect an external environment through the notch area 224a or the opening 224a. According to an embodiment, the second rear surface cover 223 may be processed to be transparent in an area corresponding to at least the camera module 216 and/or the sensor module 217. **In** some embodiments, the camera module 216 and/or the sensor module 217 may be configured to operate only when the electronic device 200 is in the slide-out state.

According to various embodiments, the electronic device 200 may include a support bracket 225 disposed in the first space 2101 of the first housing 210. According to an embodiment, the support bracket 225 may include a support portion 2252 disposed at one end and having a curved outer surface to support the rear surface of the support member 240, which is bent during the sliding operation. According to an embodiment, the support bracket 225 may include a support structure configured to support and hold the driving motor 260. According to an embodiment, the driving motor 260 may be disposed at the end (e.g., an edge) of the support bracket 225 in the slide-out direction (e.g., the y-axis direction). For example, when the assembly of the electronic device 200 is completed, the driving motor 260 is disposed at a position closest to the second printed circuit board 252 among the electronic components disposed in the first housing 210. As a result, it is possible to minimize the size and/or the length of the flexible printed circuit board F1 electrically interconnecting the second printed circuit board 252 and the driving motor 260. According to an embodiment, the electronic device 200 may include a pair of guide rails (e.g., the guide rails 226 in FIG. 6A) disposed on opposite side surfaces of the support bracket 225 to guide the opposite ends of the support member 240 in the sliding direction.

According to various embodiments, the support member 240 may include a bendable structure to support the rollable display 230 that is bent during the sliding process of the electronic device 200. For example, the support member 240 may include a plurality of bar-shaped support portions segmented from each other. Both ends of the support part included in the support member 240 may be inserted into the pair of guide rails 226. As the support unit moves along the guide rail 226, the rollable display 230 moving during the sliding process may be supported. Since the support portions are segmented from each other, the bending area (eg, the bending area 230-3 of FIGS. 6A and 6B) of the rollable display 230 may be supported.

According to various embodiments, the first housing 210 may include an opening 212a (e.g., a through hole) disposed in an area corresponding to the camera module 216 and/or the sensor module 217 disposed in the second housing 220 when the electronic device 200 is in the slide-in state in the first extension member 212. According to an embodiment, when the electronic device 200 is in the slide-in state, the camera module 216 and/or the sensor module 217 may detect an external environment through the opening 212a provided in the first housing 210. In this case, an area of the first rear surface cover 213 corresponding to at least the camera module 216 and/or the sensor module 217 may be transparent.

According to various embodiments, the electronic device 200 may include a first printed circuit board 251 and an antenna member 253 disposed between the first extension member 212 and the first rear surface cover 213 in the first housing 210. According to an embodiment, the first printed circuit board 251 and the antenna member 253 may be disposed on at least a portion of the first extension member 212. According to an embodiment, the first printed circuit board 251 and the antenna member 253 may be electrically connected to the second printed circuit board 252 via at least one flexible printed circuit board (FPCB) (or flexible RF cable (FRC)). According to an embodiment, the antenna member 253 may include a multi-function coil or multi-function core (MFC) antenna configured to execute a wireless charging function, a near field communication (NFC) function, and/or an electronic payment function. In some embodiments, the antenna member 253 may be electrically connected to the first printed circuit board 251, thereby being electrically connected to the second printed circuit board 252 via the first printed circuit board 251. In some embodiments, the first printed circuit board 251 and/or the antenna member 253 may be electrically connected to the second printed circuit board 252 via at least a portion of the flexible printed circuit board F1 connecting the driving motor 260 and the second printed circuit board 252 to each other.

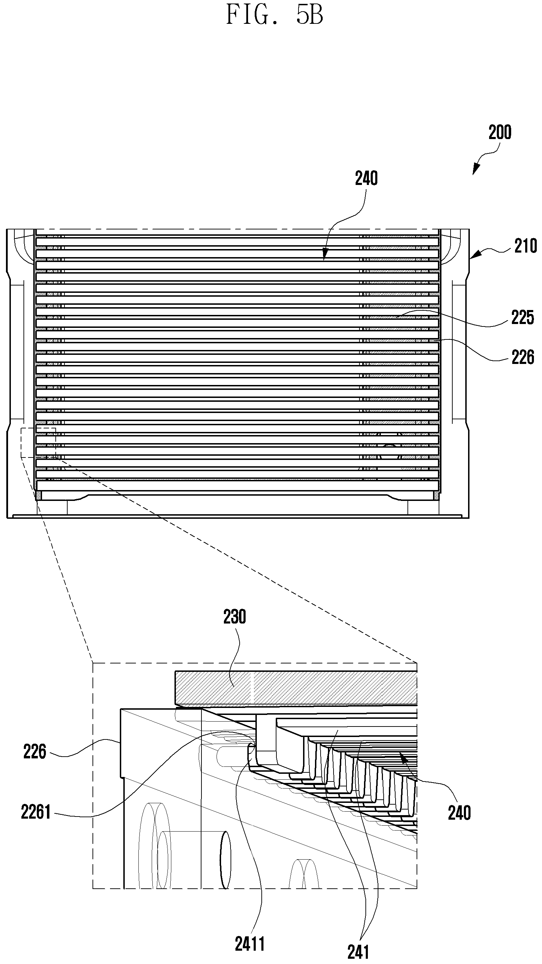

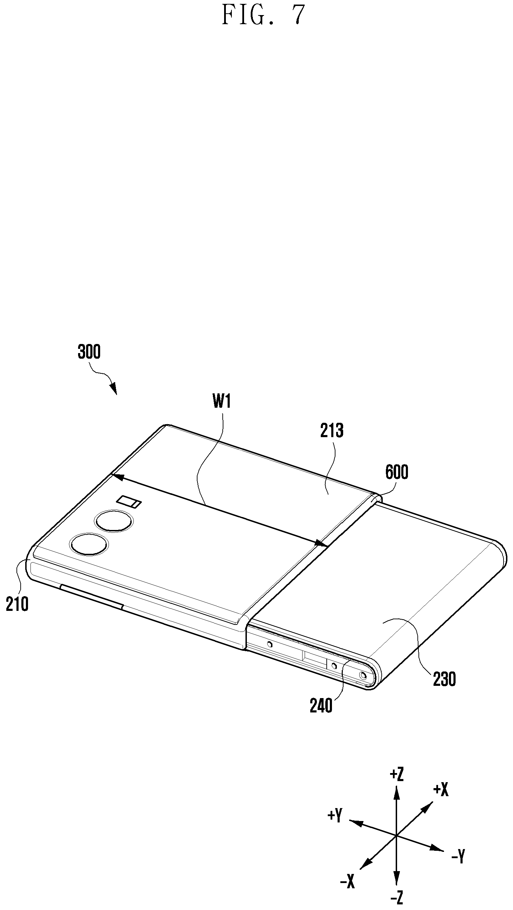

FIG. 5A is a view illustrating an arrangement structure of electronic components included in the support bracket 225 according to various embodiments of the disclosure. The support bracket illustrated in FIG. 5A may optionally be included into the electronic device described above with reference to Figures 2-4 and/or in the electronic device described below with reference to Figures 7-12. FIG. 5B is a view illustrating a portion of the configuration of an electronic device including a guide structure according to various embodiments of the disclosure.

Referring to FIG. 5A, the support bracket 225 may include: a battery seat 2251 configured to accommodate a battery B; and/or a driving motor 260. Preferably, the driving motor 260 is disposed around the battery seat 2251. An advantage of such an arrangement of the battery seat 2251 and the driving motor 260 is that the operational reliability of the electronic device may be particularly improved, as also discussed above. The driving motor may include a pinion gear 261. In some embodiments, the battery seat 2251 may be disposed to be supported via a partition wall that at least partially extends from the outer surface of the support bracket 225. In some embodiments, the battery B may be fixed to at least a portion of the support bracket 225 through an adhesion process such as bonding or taping, without a separate partition wall.

According to various embodiments, the electronic device 200 may include, in the support bracket 225, a third printed circuit board 255 (e.g., a finger PCB, a sub-substrate or FPCB) disposed near the driving motor 260. According to an embodiment, the third printed circuit board 255 may be disposed at a position to be electrically connected to a first connection portion C1 slid out from the driving motor 260 and a second connection portion C2 slid out from the battery B. For example, one end of the driving motor 260 may be electrically connected to the second printed circuit board 252 disposed in the second space 2201 of the second housing 220, and the other end of the driving motor 260 may be electrically connected to the second printed circuit board 252 via the flexible printed circuit board F1 electrically connected to the third printed circuit board 255. According to an embodiment, the flexible printed circuit board F1 may be made of an elastic material or in shape that is expanded in the slide-out state and is restored to an original position in the slide-in state. According to an embodiment, the flexible printed circuit board F1 may include a flexible printed circuit board (FPCB) or a flexible RF cable (FRC).

Referring to FIG. 5B, the electronic device 200 may include a support member 240 configured to support the rollable display 230 and a pair of guide rails 226 configured to guide opposite ends of the support member 240. According to an embodiment, the pair of guide rails 226 may be respectively fixed to opposite ends of the support bracket 225 in the first space 2101 of the first housing 210. According to an embodiment, the support member 240 may include a plurality of multi-bars 241 rotatably coupled to each other and guide protrusions 2411 protruding from opposite ends of each of the multi-bars 241. According to an embodiment, the guide rails 226 may be fixed to opposite side surfaces of the support bracket 225 disposed in the first space 2101 of the first housing 210. According to an embodiment, the guide rails 226 may each include a guide slit 2261 provided at a position corresponding to a movement trajectory of the support member 240. According to an embodiment, when the support member 240 is attached to the rear surface of the rollable display 230 is movably coupled to the guide rails 226, the guide structure in which the guide protrusions 2411 move along the guide slits 2611 may help reduce a phenomenon in which the rollable display 230 is separated or deformed during operation. Reducing this phenomenon may contribute to by reduce the stress of a part where the rollable display is deformed. Reducing the stress of a part where the rollable display is deformed may improve the durability of the rollable display.

FIG. 6A is a partial cross-sectional view of the electronic device according to various embodiments of the disclosure taken along line 6a-6a in FIG. 2A. FIG. 6B is a cross-sectional view of the electronic device according to various embodiments of the disclosure taken along line 6b-6b in FIG. 3A.

In describing the electronic device of FIGS. 6A and 6B, the same reference numerals are assigned to components that are substantially the same as those of the electronic device of FIG. 4, and a detailed description thereof may be omitted.

Referring to FIGS. 6A and 6B, the electronic device 200 may include: a first housing 210 including a first space 2101; a second housing 220 including a second space 2201; a support member 240 connected to the first housing 210 and at least partially accommodated in the first space 2101 in a bending manner in the slide-in state; a rollable display 230 disposed to be supported by at least a portion of the support member 240 and at least a portion of the second housing 220; and a driving motor 260. According to an embodiment, the driving motor may include a pinion gear (e.g., the pinion gear 261 in FIG. 5A) disposed in the first space 211 and gear-coupled with a rack gear (e.g., the rack gear 2201 in FIG. 4) in the second space 2201. According to an embodiment, the driving motor 260 may automatically move the second housing 220 in the slide-in direction (direction ②) or slide-out direction (direction ①) with reference to the first housing 210.

According to various embodiments, in the slide-in state of the electronic device 200, at least a portion of the second housing 220 may be accommodated in the first space 2101 of the first housing 210. According to an embodiment, the first extension member 212 may be slidably coupled and guided by the support bracket 225 disposed in the second space 2201.

According to various embodiments, the rollable display 230 may include a display area 230-1, an accommodation area 230-2, and a bending area 230-3. The display area 230-1, the accommodation area 230-2, and the bending area 230-3 are conceptually divided into respective areas of the rollable display 230 for convenience of description. Accordingly, respective areas may not be physically or visually differentiable. For example, when the rollable display is moved from a slide-in state to a slide-out state, or vice versa, the parts of the display area referred to as the display area 230-1, the accommodation area 230-2, and the bending area 230-3 may change accordingly. The display area 230-1 may be an area in which the rollable display 230 is visually recognized from the outside of the electronic device 200. Through the display area 230-1, the user may identify visual information displayed through the rollable display 230. The accommodation area 230-2 may be an area in which the rollable display 230 is accommodated into the electronic device 200. The accommodation area 230-2 is a portion covered by other mechanical objects (e.g., the first housing 210, the second housing 220, the first extension member 212, the second extension member 222, and the like), and may be an area that is not visually recognized from the outside of the electronic device 200. The bending area 230-3 may be an area between the display area 230-1 and the accommodation area 230-2. The bending area 230-3 may be a deformed area of the rollable display 230. The support member 240 bent according to the shape of the guide rails 226 may support the bending area 230-3. Unlike the display area 230-1 and the accommodation area 230-2 which are substantially parallel to the sliding direction of the electronic device 200 (e.g., the Y direction in FIG. 6A), the bending area 230-3 may be an area in which the rollable display 230 is maintained in a deformed state.

In various embodiments, when the second housing 220 is slid relative to the first housing 210 in direction ①, the display area 230-1 may increase and the accommodation area 230-2 may decrease. In contrast, when the first housing 210 is slid relative to the second housing 220 in direction ②, the display area 230-1 may decrease and the accommodation area 230-2 may increase. The above-described sliding of the first housing 210 may be automatically executed by the driving motor 260.

According to various embodiments, the driving motor 260 and electronic components (e.g., the first printed circuit board 251 and the battery B) arranged in the first housing 210 may move together according to the slide-in/slide-out operation of the first housing 210. There, compared to the arrangement structure in which the corresponding components are arranged in the second housing 220 and connected to the first printed circuit board 251 via electrical connection members, the number of electrical connection members are minimized, which may help improve the operation reliability of the electronic device 200 and to design an efficient arrangement of electronic components.

Electronic devices according to various embodiments disclosed in this document will be described as a first embodiment and a second embodiment, respectively. Since the electronic devices according to the first embodiment and the second embodiment include elements similar to those of the electronic device 200 described above, redundant descriptions of the elements will be omitted, and, unless necessary, descriptions will be made using the same reference numeral for the same or similar element. If necessary, the above description of the electronic device 200 may be referred to description of the first and second embodiments

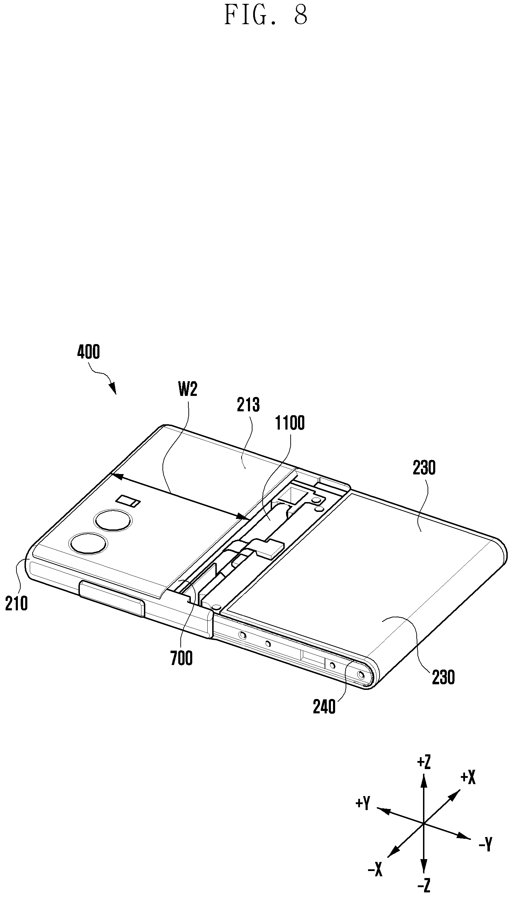

FIG. 7 is a perspective view of an electronic device according to a first embodiment disclosed in this document. FIG. 8 is a perspective view of an electronic device according to a second embodiment disclosed in this document.

FIGS. 7 and 8 may be perspective views illustrating the state in which some elements of the electronic device are removed. For example, FIGS. 7 and 8 may be perspective views illustrating the state in which a first housing (e.g., the first housing 210 in FIG. 2A) of the electronic device is removed.

An electronic device 300 of the first embodiment and an electronic device 400 of the second embodiment may include a first housing 210 and a second housing 220 slidably coupled to each other in a similar manner as the electronic device 200 described with reference to the drawings above. The electronic device 300 of the first embodiment and the electronic device 400 of the second embodiment may include a rollable display 230. According to sliding of the first housing 210 and the second housing 220, a display area (e.g., the display area 230-1 in FIGS. 6A and 6B) and a accommodation area (e.g., the accommodation area 230-2 in FIGS. 6A and 6B) of the rollable display 230 may increase or decrease. The sliding of the second housing 220 relative to the first housing 210 may be performed automatically through a moving part. The moving part may include a driving motor (e.g., the driving motor 260 in FIG. 4) The moving part may additionally include a pinion gear connected to the driving motor (e.g., the pinion gear 261 in FIG. 4), and a rack gear (e.g., the rack gear 2251 in FIG. 4) meshed with the pinion gear. The rack gear may be formed to extend along a sliding direction (e.g., the Y direction in FIGS. 7 and 8) of the electronic device 300 or 400. For example, the driving motor may be fixed to the first housing 210, and the rack gear may be formed to extend in a sliding direction of the electronic device 300 or 400 so as to be fixed to the second housing 220. According to the operation of the driving motor, the pinion gear meshed with the rack gear rotates, so that the first housing 210 may slide relative to the second housing 220.

Referring to FIGS. 7 and 8, the electronic device 300 of the first embodiment and the electronic device 400 of the second embodiment may include rear covers 600 and 700 (e.g., the rear bracket 224 in FIG. 4). Referring also to FIG. 4, the rear covers 600 and 700 may be disposed in the second housing 220 so as to cover a printed circuit board (e.g., the first board 251 in FIG. 4) disposed in the second housing 220.

According to various embodiments, the rear covers 600 and 700 may be exposed to the outside or covered by the first housing 210 according to sliding operation of the second housing 220 relative to the first housing 210. Here, the state in which the rear covers 600 and 700 are exposed to the outside may be understood as the rear covers 600 and 700 protruding from the first housing 210 (see FIG. 3B). In addition, the state in which the rear covers 600 and 700 are exposed to the outside may indicate the state in which at least a portion of the rear covers 600 and 700 is visible from the outside or the state in which the rear covers 600 and 700 are visible from the outside through a cover glass member (e.g., the first rear cover 213 in FIG. 4) disposed in the rear covers 600 and 700. A cover glass member 213 may be disposed in the rear covers 600 and 700. When the second housing 220 slides relative to the first housing 210, the cover glass member 213 disposed in the rear covers 600 and 700 may be visible from the outside of the electronic devices 300 and 400. At least a portion of the cover glass member 213 may be formed of a transparent material. Accordingly, a portion of the rear covers 600 and 700 may be visible through the cover glass member 213. In addition, if the second housing 220 slides relative to the first housing 210, the side portions of the rear covers 600 and 700 may be visible from the outside.

According to various embodiments, when the second housing 220 slides in a first direction, the display area 230-1 of the rollable display 230 may increase and the rear covers 600 and 700 may be exposed to the outside. The printed circuit board disposed in the second housing 220 may not be visible from the outside due to the rear covers 600 and 700 disposed in the second housing 220. Even if the printed circuit board disposed in the second housing 220 protrudes from the first housing 210 according to the sliding of the second housing 220, the printed circuit board may be blocked off from the outside by the rear covers 600 and 700. Accordingly, even if the second housing 220 slides, foreign substances may not directly flow to the printed circuit board from the outside.

According to various embodiments, the rear covers 600 and 700 may be formed of a stiff material, thereby assisting the strength of the second housing 220. For example, the rear covers 600 and 700 may be formed of a high-stiffness polymer material or a metal material. In some embodiments, the rear covers 600 and 700 may be formed of a material different from that of the second housing 220. As the high-stiffness rear covers 600 and 700 are coupled to the second housing 220, the strength of the second housing 220 may be reinforced. For example, if the plate-shaped rear covers 600 and 700 are coupled to the second housing 220, torsional stiffness of the assembly of the rear covers 600 and 700 and the second housing 220 may be improved.

Referring to FIGS. 7 and 8, the rear cover 600 of the first embodiment and the rear cover 700 of the second embodiment may have different lengths in a first direction (e.g., the Y direction in FIGS. 7 and 8). For example, a first direction length W2 of the rear cover 700 included in the electronic device 400 of the second embodiment may be less than a first direction length W1 of the rear cover 600 included in the electronic device 300 of the first embodiment.

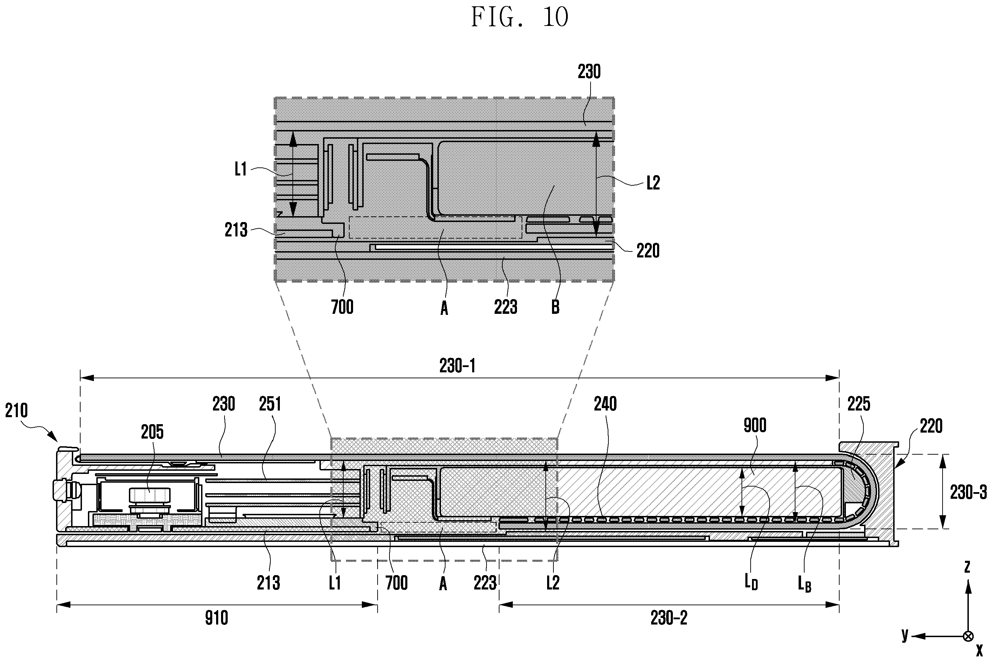

The rear cover 700 of the second embodiment may be provided so as not to face a battery (e.g., the battery 900 in FIG. 10) of the electronic device 400. In addition, the rear cover 700 of the second embodiment may be formed so as not to face the driving motor 1100 of the electronic device 400.

Referring to FIGS. 7 and 8, in the case of the first embodiment, there may not be a space between the rear cover 600 and the rollable display 230 when the electronic device 300 is in a full slide-in state. For example, the rollable display 230 and the rear cover 600 may partially overlap each other in a third direction (e.g., the Z direction in FIG. 7). On the other hand, in the case of the second embodiment shown in FIG. 8, the rear cover 700 and the rollable display 230 may be separated from each other when the electronic device 400 is in a full slide-in state. An expansion space (e.g., the expansion space A in FIG. 10) may be provided between the rear cover 700 and the rollable display 230. In other words, the rear cover 700 and the rollable display 230 may not overlap each other in the third direction.

Compared to the electronic device 300 of the first embodiment, the electronic device 400 of the second embodiment may secure a larger battery size using the expansion space. In addition, the expansion space may be used to dispose a driving motor having a larger diameter. For example, a portion of the expansion space may be used for increasing the size of the battery and a portion of the expansion space may be used for increasing the diameter for the driving motor. Of course, it is alternatively possible that the expansion space is only used for the larger battery or for the driving motor with increased diameter. In some embodiments, the expansion space may enable to secure a space in which electric components or structures may be disposed.

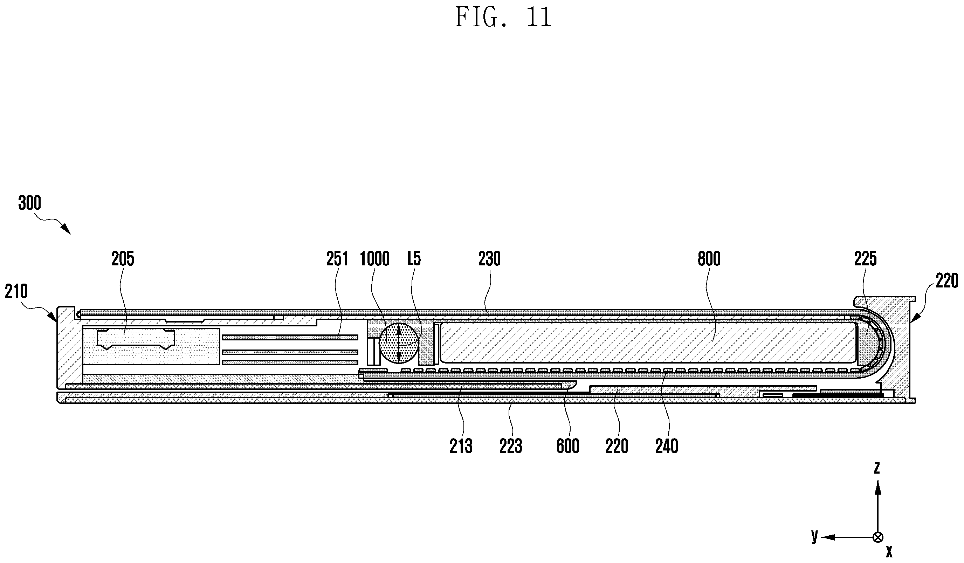

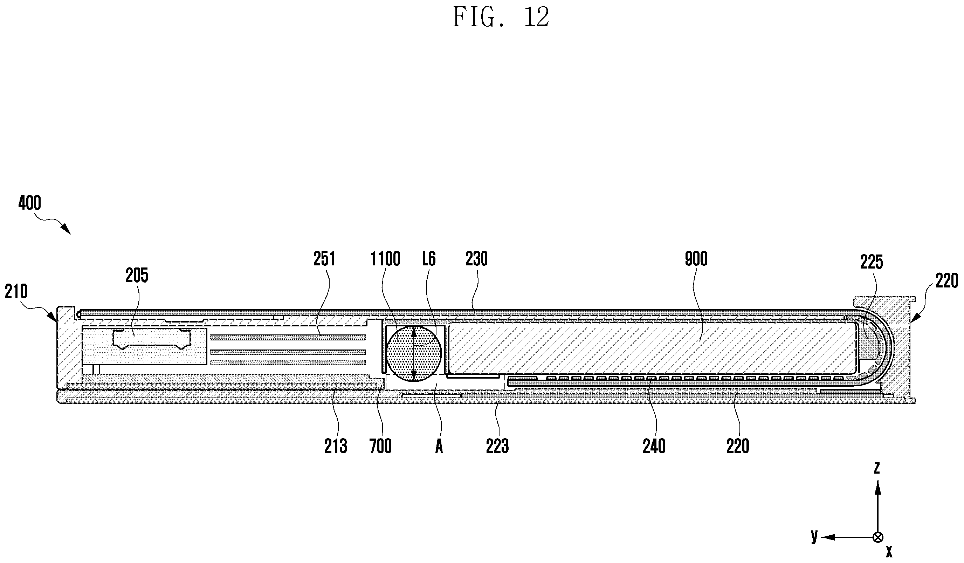

FIG. 9 is a cross-sectional view of the electronic device according to the first embodiment cut along a sliding direction. FIG. 10 is a cross-sectional view of the electronic device according to the second embodiment cut along a sliding direction. FIG. 11 is a cross-sectional view of the electronic device according to the first embodiment cut along a sliding direction so that a driving motor is visible. FIG. 12 is a cross-sectional view of the electronic device according to the second embodiment cut along the sliding direction so that the driving motor is visible.

According to various embodiments, the length in a first direction (e.g., the Y direction in FIGS. 9 and 10) and the length in a third direction (e.g., the Z direction in FIGS. 9 and 10) of the electronic device 300 of the first embodiment and the electronic device 400 of the second embodiment may be substantially the same.

Referring to FIG. 9, in the first embodiment, the rear cover 600 may be formed to face the accommodation area 230-2 of the rollable display 230. The cover glass member 213 disposed in the rear cover 600 may also face the accommodation area 230-2. In the first embodiment, the rear cover 600 and the cover glass member 213 may overlap the accommodation area 230-2 in the third direction (e.g., the Z direction in FIG. 9). One surface of the first housing 210 may be a surface facing the battery 800, and the opposite surface of the first housing 210 may be a surface facing the rear cover 223. A battery 800 may be accommodated in a support bracket 225 disposed to cover the battery 800. The support bracket 225 may be disposed between the display area 230-1 and the accommodation area 230-2 when the electronic device 300 is in a slide-in state.

Referring to FIG. 10, in the second embodiment, the rear cover 700 may be formed to not face the accommodation area 230-2 of the rollable display 230. The cover glass member 213 disposed in the rear cover 700 may not face either the accommodation area 230-2. In the second embodiment, the rear cover 700 and the cover glass member 213 may not overlap the accommodation area 230-2 in the third direction (e.g., the Z direction in FIG. 9). In some embodiments, the rear cover 700 and the cover glass member 213 may extend to an end portion of the accommodation area 230-2 of the rollable display 230. One surface of the first housing 210 may be a surface facing the battery 900, and the opposite surface of the first housing 210 may be a surface facing the rear cover 223. A battery 900 may be accommodated in a support bracket 225 disposed to cover the battery 900. The support bracket 225 may be disposed between the display area 230-1 and the accommodation area 230-2 when the electronic device 300 is in a slide-in state.

According to various embodiments, as shown in FIGS. 9 and 10, the batteries 800 and 900 may be disposed in the display area 230-1 and the accommodation area 230-2 of the rollable display 230 when the electronic devices 300 and 400 are in the slide-in state. In the case of a slidable electronic device, the size and disposed location of an internal component such as the battery 800 or 900 may be designed based on the full slide-in state of the electronic device 300 or 400 as shown in FIGS. 9 and 10. Accordingly, the sizes of the batteries 800 and 900 may also be determined based on the space in the full slide-in state of the electronic devices 300 and 400.

Referring to FIGS. 9 and 10, a first distance L1, which is a separation distance between the rear cover 600 or 700 and the display area 230-1 of the rollable display 230 in the third direction (e.g., the Z direction in FIGS. 9 and 10) perpendicular to the sliding direction (e.g., the Y direction in FIGS. 9 and 10) of the electronic device 300 or 400, may be less than a second distance L2, which is a separation distance between one surface of the first housing 210 and the display area 230-1 of the rollable display 230 in the third direction. Since the rear covers 600 and 700 are elements configured to be received inside the first housing 210, in the slide-in state, the first distance L1 between the rear cover 600 or 700 and the display area 230-1 may be less than the second distance L2 between the first housing 210 and the display area 230-1.

The batteries 800 and 900 may be disposed between the display area 230-1 and the accommodation area 230-2. The accommodation area 230-2 and the length of the battery 800 or 900 in the third direction (hereinafter referred to as a "height of the battery") L_{C} or L_{D} may increase as the distance L_{A} or L_{B} between the display area 230-1 and the accommodation area 230-2 is secured. In order to reduce the stress applied to the rollable display 230, the accommodation area 230-2 may be substantially flat in the first direction. For example, a guide rail (e.g., the guide rail 226 in FIG. 4) by which a support member 240 supporting the rollable display 230 is guided may have a portion corresponding to the accommodation area 230-2 and formed substantially parallel to the first direction. Accordingly, the distance L_{A} or L_{B} between the display area 230-1 and the accommodation area 230-2 may be determined by the distance between the structure facing the accommodation area 230-2 and the display area 230-1.

In the first embodiment, since the rear cover 600 extends to the location facing the rollable display 230, the accommodation area 230-2 of the rollable display 230 may face the rear cover 600. In the second embodiment, since the rear cover 700 does not face the rollable display 230, the accommodation area 230-2 of the rollable display 230 may face one surface of the first housing 210, instead of the rear cover 600. As described above, the first distance L1 between the rear cover 600 or 700 and the display area 230-1 may be less than the second distance L2 between the first housing 210 and the display area 230-1. Accordingly, the distance L_{B} between the display area 230-1 and the accommodation area 230-2 in the second embodiment may be greater than the distance L_{B} between the display area 230-1 and the accommodation area 230-2 in the first embodiment. Compared to the first embodiment, the second embodiment may secure a larger distance between the display area 230-1 and the accommodation area 230-2 (L_{A} < L_{B}).

The heights L_{C} and L_{D} of the batteries 800 and 900 may be summarized as follows. The heights L_{C} and L_{D} of the batteries 800 and 900 disposed between the display area 230-1 and the accommodation area 230-2 may be determined by the distances L_{A} and L_{B} between the display area 230-1 and the accommodation area 230-2. The distances L_{A} and L_{B} between the display area 230-1 and the accommodation area 230-2 may be determined according to the distance between the structure facing the accommodation area 230-2 and the display area 230-1. In the case of the second embodiment, the accommodation area 230-2 may face one surface of the first housing 210, instead of facing the rear cover 700. In the case of the first embodiment, the accommodation area 230-2 may face the rear cover 600. The second distance L2, which is the distance between the first housing 210 and the display area 230-1, is greater than the first distance L1, which is the distance between the rear covers 600 and 700 and the display area 230-1. Accordingly, in the case of the second embodiment, since the distance between the display area 230-1 and the accommodation area 230-2 may be secured more than in the first embodiment (L_{A} < L_{B}), the height L_{D} of the battery 900 in the second embodiment may be greater than the height L_{C} of the battery 800 in the first embodiment. The capacities of the batteries 800 and 900 may be proportional to the volumes of the batteries 800 and 900. If the batteries 800 and 900 have the same first direction length, the capacities of the batteries 800 and 900 may be determined according to the heights L_{C} and L_{D} of the batteries 800 and 900. Since the structure of the second embodiment may enable disposition of the battery 900 having a higher height, compared to the structure of the first embodiment, the battery 900 having a capacity greater than the battery 800 of the first embodiment may be disposed (L_{C} < L_{D}).

In various embodiments, a bending area230-3 of the rollable display 230 may be an area that connects the accommodation area 230-2 and the display area 230-1 and is to be bent. The curvature radius of the bending area230-3 may vary depending on the distance L_{A} or L_{B} between the accommodation area 230-2 and the display area 230-1. The smaller the distance L_{A} or L_{B} between the accommodation area 230-2 and the display area 230-1, the curvature radius may be smaller. If the curvature radius is reduced, deformation stress applied to the rollable display 230 may increase, thereby lowering the durability of the rollable display 230. In the case of the second embodiment, a greater distance between the accommodation area 230-2 and the display area 230-1 may be secured compared to the first embodiment (L_{A} < L_{B}). Accordingly, the curvature radius of the rollable display 230 in the second embodiment may be greater than the curvature radius of the rollable display 230 in the first embodiment.

In the case of the second embodiment, compared to the first embodiment, the distance L_{B} between the accommodation area 230-2 and the display area 230-1 may be further secured by a difference between the second distance L2, which is a distance between the display area 230-1 and the first housing 210, and the first distance L1, which is a distance between the display area 230-1 and the rear cover 700. In the second embodiment, a repellant force of the rollable display 230 may be reduced by increasing the curvature radius of the rollable display 230 by securing the distance L_{B} between the accommodation area 230-2 and the display area 230-1, thereby reducing the stress of the rollable display 230 applied in the bending area230-3. Accordingly, the durability of the rollable display 230 may be improved.

According to various embodiments, in the second embodiment, the maximum length of the display area 230-1 of the rollable display 230 (the length of the display area 230-1 in the Y-axis direction when the first housing 210 fully slides relative to the second housing 220) may be determined according to the overlapping portion of the first housing 210 and the second housing 220 (e.g., the overlapping portion 910 in FIG. 10). The first housing 210 may slide relative to the second housing 220 in the Y-axis direction, based on FIG. 10, by the length of the overlapping portion 910. If the second housing 220 slides relative to the first housing 210 beyond the overlapping portion 910, the inside between the first housing 210 and the second housing 220 may be visible from the outside. Accordingly, the maximum length of the display area 230-1 of the rollable display 230 may be determined by the length of the overlapping portion 910 of the first housing 210 and the second housing 220.

Referring to FIGS. 11 and 12, driving motors 1000 and 1100 may be disposed between the batteries 800 and 900 and the printed circuit board 251. In the first embodiment, the driving motor 1000 may face the rear cover 600. On the other hand, in the second embodiment, the driving motor 1100 may not face the rear cover 700. Accordingly, the second embodiment may secure a more space in the third direction (e.g., the Z direction in FIG. 12) for the driving motor 1100, compared to the first embodiment. The size L6 of the driving motor 1100 of the second embodiment may be greater than the size L5 of the driving motor 1000 of the first embodiment. For example, as shown in FIG. 12, the driving motor 1100 may occupy at least a portion of the expansion space A provided between the rear cover 700 and the rollable display 230. A larger driving motor may have a higher driving force (e.g., torque) thereof. Accordingly, the driving motor 1100 of the second embodiment may have a higher driving force than the driving motor 1000 of the first embodiment.

In some embodiments, similar to the second embodiment, the rear cover 700 may be formed such that the rear cover 700 and the rollable display 230 do not face each other, and an additional battery (not shown) separated from the battery 900 may be disposed in the expansion space A between the rear cover 700 and the rollable display 230.

The additional battery may be electrically connected to the battery 900. In this way, the battery 900 and the additional battery effectively form one (larger) battery. The additional battery may be formed in a shape corresponding to the expansion space A or may be formed in a shape capable of occupying a portion of the expansion space A.

An electronic device (e.g., the electronic device 400 in FIG. 8) according to various embodiments disclosed in this document may include a first housing (e.g., the first housing 210 in FIG. 10), a second housing (e.g., the second housing 220 in FIG. 10) coupled to the first housing so as to slide in a first direction and in a second direction opposite the first direction, a printed circuit board (e.g., the printed circuit board 251 in FIG. 10) disposed in the second housing, a rear cover (e.g., the rear cover 700 in FIG. 8) disposed in the second housing and configured to support the printed circuit board, a rollable display (e.g., the rollable display 230 in FIG. 8) including a display area (e.g., the display area 230-1 in FIG. 10) exposed to the outside of the electronic device, a accommodation area (e.g., the accommodation area 230-2 in FIG. 10) received inside the electronic device, and a bending area(e.g., the bending area230-3 in FIG. 10) connecting the display area and the accommodation area and configured to be bent, and having a display area that is reduced or expanded based on a sliding-in or sliding-out operation of the second housing, and a battery (e.g., the battery 900 in FIG. 10) disposed in a space provided in the first housing and the second housing, wherein the rear cover may be formed so as not to overlap the accommodation area of the rollable display when the rollable display is viewed vertically when the second housing is in a full slide-in state in the second direction.

In addition, an expansion space A may be provided between the rear cover and the rollable display, and the battery may be configured to occupy the expansion space in a third direction perpendicular to the first and second directions.

In addition, the battery, in a slide-in state, may be disposed in a position not facing the rear cover and disposed between the display area and the accommodation area of the rollable display.

In addition, a first distance corresponding to a distance between the display area of the rollable display and the rear cover in the third direction may be less than a second distance corresponding to a distance between the display area of the rollable display and one surface of the first housing in the third direction.

In addition, the accommodation area of the rollable display may be substantially flat in the first direction and the second direction.

In addition, the accommodation area of the rollable display may be disposed to not face the rear cover so that the accommodation area may be further spaced from the display area by a distance corresponding to a difference between the second distance and the first distance and so that a curvature radius of the bending areamay be increased.

In addition, the accommodation area of the rollable display may be disposed between the battery and the first housing.

In addition, the electronic device may further include a support member (e.g., the support member 240 in FIG. 10) configured to support the rollable display to be bendable.

In addition, the electronic device may further include a guide rail (e.g., the guide rail 226 in FIG. 4) configured to guide movement of the support member according to sliding of the second housing.

In addition, the support member may include a plurality of bar-shaped support portions segmented from each other, and both ends of the support portion may be inserted into the guide rail.

In addition, the guide rail may have a portion corresponding to the accommodation area of the rollable display, which is formed parallel to the first direction and the second direction.

In addition, the electronic device may further include a cover glass member (e.g., the cover glass member 213 in FIG. 10) coupled to the rear cover, and the cover glass member may be formed so as not to face the rollable display having slid into the electronic device when the second housing is in a full slide-in state in the first direction.

An electronic device (e.g., the electronic device 400 in FIG. 8) according to various embodiments disclosed in this document may include a first housing (e.g., the first housing 210 in FIG. 12), a second housing (e.g., the second housing 220 in FIG. 12) coupled to the first housing so as to slide in a first direction and in a second direction opposite the first direction, a printed circuit board (e.g., the printed circuit board 251 in FIG. 12) disposed in the second housing, a rear cover (e.g., the rear cover 700 in FIG. 12) disposed in the second housing to cover the printed circuit board and configured to be covered by the first housing or exposed to the outside of the electronic device according to sliding of the second housing relative to the first housing, a rollable display (e.g., the rollable display 230 in FIG. 8) including a display area (e.g., the display area 230-1 in FIG. 12) exposed to the outside of the electronic device, a accommodation area (e.g., the accommodation area 230-2 in FIG. 12) received inside the electronic device, and a bending area(e.g., the bending area230-3 in FIG. 12) connecting the display area and the accommodation area and configured to be bent, and having a display area that is reduced or expanded based on a sliding-in or sliding-out operation of the second housing, and a moving part including a driving motor disposed in the first housing and configured to drive the second housing to slide in or slide out, wherein the rear cover may be formed so as not to overlap the accommodation area of the rollable display when the rollable display is viewed vertically when the second housing is in a full slide-in state in the second direction, wherein an expansion space may be provided between the rear cover and the rollable display, and wherein at least a portion of the driving motor of the moving part may be configured to occupy the expansion space.

In addition, the moving part may include a pinion gear (e.g., the pinion gear 261 in FIG. 4) connected to the driving motor and a rack gear (e.g., the rack gear 2251 in FIG. 4) formed to extend in the first direction and the second direction and meshed with the pinion gear.

In addition, a first distance corresponding to a distance between the display area of the rollable display and the rear cover in the third direction may be less than a second distance corresponding to a distance between the display area of the rollable display and one surface of the first housing in the third direction.

In addition, the accommodation area of the rollable display may be disposed to not face the rear cover so that the accommodation area may be further spaced from the display area by a distance corresponding to a difference between the second distance and the first distance and so that a curvature radius of the bending areamay be increased.

In addition, the electronic device may further include a battery (e.g., the battery 900 in FIG. 12) disposed in a space provided between the first housing and the second housing, and the accommodation area of the rollable display may be disposed between the battery and the first housing.

In addition, the electronic device may further include a support member (e.g., the support member 240 in FIG. 10) configured to support the rollable display to be bendable.

In addition, the electronic device may further include a guide rail (e.g., the guide rail 226 in FIG. 4) configured to guide movement of the support member according to sliding of the first housing.

In addition, the support member may include a plurality of bar-shaped support portions segmented from each other, and both ends of the support portion may be inserted into the guide rail.

In addition, the guide rail may have a portion corresponding to the accommodation area of the rollable display, which is formed parallel to the first direction and the second direction.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities mat be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device comprising:
a first housing (210);
a second housing (220) coupled to the first housing (210) so as to slide in a first direction (①) and in a second direction (②) opposite the first direction (①);
a printed circuit board (251) disposed in the second housing (220);
a rear cover (700) disposed in the second housing (220) and configured to support the printed circuit board (251);
a rollable display (230) comprising a display area (230-1) exposed to the outside of the electronic device, an accommodation area (230-2) accommodated inside the electronic device, and a bending area (230-3) connecting the display area (230-1) and the accommodation area (230-2) and configured to be bent, and wherein the display area (230-1) is reduced or expanded based on a sliding-in or sliding-out operation of the second housing (220);
a driving motor (260) disposed in the first housing (210) and configured to drive the second housing (220) to slide in or slide out; and
a battery (900) disposed in a space provided in the first housing (210) and the second housing (220),
wherein the rear cover (700) is formed so as not to overlap the accommodation area (230-2) of the rollable display (230) when the rollable display (230) is viewed vertically and when the second housing (220) is in a full slide-in state in the second direction (②).

2. The electronic device of claim 1, wherein an expansion space (A) is provided between the rear cover (700) and the rollable display (230), and wherein at least a portion of the battery (900) is configured to occupy at least a portion of the expansion space (A) in a third direction (Z) perpendicular to the first (①) and second (②) directions.

3. The electronic device of claim 1, wherein the battery (900), in a slide-in state, is disposed in a position not facing the rear cover (700) and is disposed between the display area (230-1) and the accommodation area (230-2) of the rollable display (230).

4. The electronic device of claim 1, wherein a first distance (L1) corresponding to a distance between the display area (230-1) of the rollable display (230) and the rear cover (700) in a third direction (Z) perpendicular to the first direction (①) and the second direction (②) is less than a second distance (L2) corresponding to a distance between the display area (230-1) of the rollable display (230) and one surface of the first housing (210) in the third direction (Z).

5. The electronic device of claim 4, wherein the accommodation area (230-2) of the rollable display (230) is substantially flat in the first direction (①) and the second direction (②).

6. The electronic device of claim 5, wherein the accommodation area (230-2) of the rollable display (230) is disposed to not face the rear cover (700) so that the accommodation area (230-2) is further spaced from the display area (230-1) by a distance corresponding to a difference between the second distance (L2) and the first distance (L1) and so that a curvature radius of the bending area (230-3) is increased.

7. The electronic device of claim 1, wherein the accommodation area (230-2) of the rollable display (230) is disposed between the battery (900) and the first housing (210).

8. The electronic device of claim 1, further comprising a support member (240) configured to support the bending area (230-3) of the rollable display (230), and a guide rail (226) configured to guide movement of the support member (240) according to sliding of the second housing (220), wherein the support member (240) comprises a plurality of bar-shaped support portions segmented from each other, and wherein both ends of the support portions are inserted into the guide rail (226).

9. The electronic device of claim 1, further comprising a cover glass member (213) coupled to the rear cover(700),
wherein the cover glass member (213) is formed so as not to face the rollable display (230) having slid into the electronic device when the second housing (220) is in a full slide-in state in the first direction (①).

10. The electronic device of claim 1, wherein
the rear cover (700) covers the printed circuit board (251) and is configured to be covered by the first housing (210) or exposed to the outside of the electronic device according to sliding of the second housing (220) relative to the first housing (210); and
further comprising a moving part comprising the driving motor (260), and
wherein an expansion space (A) is provided between the rear cover (700) and the rollable display (230), and wherein at least a portion of the driving motor (260) of the moving part is configured to occupy the expansion space (A).

11. The electronic device of claim 10, wherein the moving part comprises a pinion gear (261) connected to the driving motor (260) and a rack gear (2221) formed to extend in the first direction (①) and the second direction (②) and meshed with the pinion gear (261).

12. The electronic device of claim 10, wherein a first distance (L1) corresponding to a distance between the display area (230-1) of the rollable display (230) and the rear cover (700) in a third direction (Z) perpendicular to the first direction (①) and the second direction (②) is less than a second distance (L2) corresponding to a distance between the display area (230-1) of the rollable display (230) and one surface of the first housing (210) in the third direction (Z).

13. The electronic device of claim 12, wherein the accommodation area (230-2) of the rollable display (230) is disposed to not face the rear cover (700) so that the accommodation area (230-2) is further spaced from the display area (230-1) by a distance corresponding to a difference between the second distance (L2) and the first distance (L1) and so that a curvature radius of the bending area (230-3) is increased.

14. The electronic device of claim 10, further comprising a battery (900) disposed in a space provided between the first housing (210) and the second housing (220),
wherein the accommodation area (230-2) of the rollable display (230) is disposed between the battery (900) and the first housing (210).

15. The electronic device of claim 10, further comprising a support member (240) configured to support the rollable display (230) to be bendable, anda guide rail (226) configured to guide movement of the support member (240) according to sliding of the first housing (210), wherein the support member (240) comprises a plurality of bar-shaped support portions segmented from each other, and wherein both ends of the support portions are inserted into the guide rail (226).

## Patentansprüche

1. Elektronische Vorrichtung, die Folgendes umfasst:
ein erstes Gehäuse (210);
ein zweites Gehäuse (220), das mit dem ersten Gehäuse (210) so gekoppelt ist, dass es in eine erste Richtung (①) und in eine zweite Richtung (②) gleitet, die der ersten Richtung (①) entgegengesetzt ist;
eine Leiterplatte (251), die in dem zweiten Gehäuse (220) angeordnet ist;
eine hintere Abdeckung (700), die in dem zweiten Gehäuse (220) angeordnet und so konfiguriert ist, dass sie die Leiterplatte (251) trägt;
ein aufrollbares Display (230), das einen zu der Außenseite der elektronischen Vorrichtung hin freiliegenden Anzeigebereich (230-1), einen in dem Inneren der elektronischen Vorrichtung untergebrachten Aufnahmebereich (230-2) und einen Biegebereich (230-3) umfasst, der den Anzeigebereich (230-1) und den Aufnahmebereich (230-2) verbindet und so konfiguriert ist, dass er gebogen werden kann, und wobei der Anzeigebereich (230-1) basierend auf einer Einschub- oder Ausziehbewegung des zweiten Gehäuses (220) verkleinert oder vergrößert wird;
einen Antriebsmotor (260), der in dem ersten Gehäuse (210) angeordnet und so konfiguriert ist, dass er das zweite Gehäuse (220) zum Einschieben oder Herausschieben antreibt; und
eine Batterie (900), die in einem Raum angeordnet ist, der in dem ersten Gehäuse (210) und dem zweiten Gehäuse (220) vorgesehen ist,
wobei die hintere Abdeckung (700) so ausgebildet ist, dass sie den Aufnahmebereich (230-2) des aufrollbaren Displays (230) nicht überlappt, wenn das aufrollbare Display (230) vertikal betrachtet wird und wenn sich das zweite Gehäuse (220) in einem vollständig eingeschobenen Zustand in der zweiten Richtung (②) befindet.

2. Elektronische Vorrichtung nach Anspruch 1, wobei zwischen der hinteren Abdeckung (700) und dem aufrollbaren Display (230) ein Erweiterungsraum (A) vorgesehen ist und wobei mindestens ein Teil der Batterie (900) so konfiguriert ist, dass sie mindestens einen Teil des Erweiterungsraums (A) in einer dritten Richtung (Z) senkrecht zu der ersten (①) und zweiten (②) Richtung einnimmt.

3. Elektronische Vorrichtung nach Anspruch 1, wobei die Batterie (900) in einem eingeschobenen Zustand in einer Position angeordnet ist, die der hinteren Abdeckung (700) nicht zugewandt ist, und zwischen dem Anzeigebereich (230-1) und dem Aufnahmebereich (230-2) des aufrollbaren Displays (230) angeordnet ist.

4. Elektronische Vorrichtung nach Anspruch 1, wobei ein erster Abstand (L1), der einem Abstand zwischen dem Anzeigebereich (230-1) des aufrollbaren Displays (230) und der hinteren Abdeckung (700) in einer dritten Richtung (Z) senkrecht zu der ersten Richtung (①) und der zweiten Richtung (②) entspricht, kleiner als ein zweiter Abstand (L2) ist, der einem Abstand zwischen dem Anzeigebereich (230-1) des aufrollbaren Displays (230) und einer Oberfläche des ersten Gehäuses (210) in der dritten Richtung (Z) entspricht.

5. Elektronische Vorrichtung nach Anspruch 4, wobei der Aufnahmebereich (230-2) des aufrollbaren Displays (230) in der ersten Richtung (①) und der zweiten Richtung (②) im Wesentlichen flach ist.

6. Elektronische Vorrichtung nach Anspruch 5, wobei der Aufnahmebereich (230-2) des aufrollbaren Displays (230) so angeordnet ist, dass er der hinteren Abdeckung (700) nicht zugewandt ist, so dass der Aufnahmebereich (230-2) von dem Anzeigebereich (230-1) weiter um einen Abstand beabstandet ist, der einer Differenz zwischen dem zweiten Abstand (L2) und dem ersten Abstand (L1) entspricht, und so dass ein Krümmungsradius des Biegebereichs (230-3) vergrößert wird.

7. Elektronische Vorrichtung nach Anspruch 1, wobei der Aufnahmebereich (230-2) des aufrollbaren Displays (230) zwischen der Batterie (900) und dem ersten Gehäuse (210) angeordnet ist.

8. Elektronische Vorrichtung nach Anspruch 1, die ferner ein Stützelement (240), das so konfiguriert ist, dass es den Biegebereich (230-3) des aufrollbaren Displays (230) stützt, und eine Führungsschiene (226) umfasst, die so konfiguriert ist, dass sie die Bewegung des Stützelements (240) entsprechend dem Verschieben des zweiten Gehäuses (220) führt, wobei das Stützelement (240) eine Vielzahl von stabförmigen Stützabschnitten umfasst, die voneinander segmentiert sind, und wobei beide Enden der Stützabschnitte in die Führungsschiene (226) eingeführt sind.

9. Elektronische Vorrichtung nach Anspruch 1, die ferner ein Deckglaselement (213) umfasst, das mit der hinteren Abdeckung (700) gekoppelt ist,
wobei das Deckglaselement (213) so ausgebildet ist, dass es dem aufrollbaren Display (230) nicht zugewandt ist, das in die elektronische Vorrichtung eingeschoben ist, wenn sich das zweite Gehäuse (220) in einem vollständig eingeschobenen Zustand in der ersten Richtung (①) befindet.

10. Elektronische Vorrichtung nach Anspruch 1, wobei die hintere Abdeckung (700) die Leiterplatte (251) bedeckt und so konfiguriert ist, dass sie entsprechend dem Verschieben des zweiten Gehäuses (220) relativ zum ersten Gehäuse (210) von dem ersten Gehäuse (210) abgedeckt oder zur Außenseite der elektronischen Vorrichtung hin freigelegt wird; und
die ferner einen beweglichen Teil umfasst, der den Antriebsmotor (260) umfasst, und
wobei zwischen der hinteren Abdeckung (700) und dem aufrollbaren Display (230) ein Erweiterungsraum (A) vorgesehen ist und wobei mindestens ein Teil des Antriebsmotors (260) des beweglichen Teils so konfiguriert ist, dass er den Erweiterungsraum (A) einnimmt.

11. Elektronische Vorrichtung nach Anspruch 10, wobei der bewegliche Teil ein mit dem Antriebsmotor (260) verbundenes Ritzel (261) und eine Zahnstange (2221) umfasst, die so ausgebildet ist, dass sie sich in die erste Richtung (①) und die zweite Richtung (②) erstreckt und mit dem Ritzel (261) kämmt.

12. Elektronische Vorrichtung nach Anspruch 10, wobei ein erster Abstand (L1), der einem Abstand zwischen dem Anzeigebereich (230-1) des aufrollbaren Displays (230) und der hinteren Abdeckung (700) in einer dritten Richtung (Z) senkrecht zu der ersten Richtung (①) und der zweiten Richtung (②) entspricht, kleiner als ein zweiter Abstand (L2) ist, der einem Abstand zwischen dem Anzeigebereich (230-1) des aufrollbaren Displays (230) und einer Oberfläche des ersten Gehäuses (210) in der dritten Richtung (Z) entspricht.

13. Elektronische Vorrichtung nach Anspruch 12, wobei der Aufnahmebereich (230-2) des aufrollbaren Displays (230) so angeordnet ist, dass er der hinteren Abdeckung (700) nicht zugewandt ist, so dass der Aufnahmebereich (230-2) von dem Anzeigebereich (230-1) weiter um einen Abstand beabstandet ist, der einer Differenz zwischen dem zweiten Abstand (L2) und dem ersten Abstand (L1) entspricht, und so dass ein Krümmungsradius des Biegebereichs (230-3) vergrößert wird.

14. Elektronische Vorrichtung nach Anspruch 10, die ferner eine Batterie (900) umfasst, die in einem zwischen dem ersten Gehäuse (210) und dem zweiten Gehäuse (220) vorgesehenen Raum angeordnet ist,
wobei der Aufnahmebereich (230-2) des aufrollbaren Displays (230) zwischen der Batterie (900) und dem ersten Gehäuse (210) angeordnet ist.

15. Elektronische Vorrichtung nach Anspruch 10, die ferner ein Stützelement (240), das so konfiguriert ist, dass es das aufrollbare Display (230) biegbar stützt, und eine Führungsschiene (226) umfasst, die so konfiguriert ist, dass sie die Bewegung des Stützelements (240) entsprechend dem Verschieben des ersten Gehäuses (210) führt, wobei das Stützelement (240) eine Vielzahl von stabförmigen Stützabschnitten umfasst, die voneinander segmentiert sind, und wobei beide Enden der Stützabschnitte in die Führungsschiene (226) eingeführt sind.

## Revendications

1. Dispositif électronique comprenant :
un premier boîtier (210) ;
un deuxième boîtier (220) couplé au premier boîtier (210) de manière à coulisser dans une première direction (①) et dans une deuxième direction (②) opposée à la première direction (①) ;
une carte de circuit imprimé (251) disposée dans le deuxième boîtier (220) ;
un couvercle arrière (700) disposé dans le deuxième boîtier (220) et configuré pour supporter la carte de circuit imprimé (251) ;
un écran enroulable (230) comprenant une zone d'écran (230-1) exposée à l'extérieur du dispositif électronique, une zone de logement (230-2) logée à l'intérieur du dispositif électronique, et une zone de flexion (230-3) reliant la zone d'écran (2-10-1) et la zone de logement (230-2) et configurée pour être pliée, et où la zone d'écran (230-1) est réduite ou étendue en fonction d'une opération de coulissement vers l'intérieur ou de coulissement vers l'extérieur du deuxième boîtier (220) ;
un moteur d'entraînement (260) disposé dans le premier boîtier (210) et configuré pour entraîner le deuxième boîtier (220) à coulisser vers l'intérieur ou à coulisser vers l'extérieur ; et
une batterie (900) disposée dans un espace prévu dans le premier boîtier (210) et dans le deuxième boîtier (220),
où le couvercle arrière (700) est formé de manière à ne pas chevaucher la zone de logement (230-2) de l'écran enroulable (230) lorsque l'écran enroulable (230) est vu verticalement et lorsque le deuxième boîtier (220) est dans un état de coulissement vers l'intérieur complet dans la deuxième direction (②).

2. Dispositif électronique selon la revendication 1, où un espace d'expansion (A) est prévu entre le couvercle arrière (700) et l'écran enroulable (230), et où au moins une partie de la batterie (900) est configurée pour occuper au moins une partie de l'espace d'expansion (A) dans une troisième direction (Z) perpendiculaire à la première (①) et à la deuxième (②) direction.

3. Dispositif électronique selon la revendication 1, où la batterie (900), dans un état de coulissement vers l'intérieur, est disposée dans une position qui ne fait pas face au couvercle arrière (700) et est disposée entre la zone d'écran (230-1) et la zone de logement (230-2) de l'écran enroulable (230).

4. Dispositif électronique selon la revendication 1, où une première distance (L1) correspondant à une distance entre la zone d'écran (230-1) de l'écran enroulable (230) et le couvercle arrière (700) dans une troisième direction (Z) perpendiculaire à la première direction (①) et à la deuxième direction (②) est inférieure à une deuxième distance (L2) correspondant à une distance entre la zone d'écran (230-1) de l'écran enroulable (230) et une surface du premier boîtier (210) dans la troisième direction (Z).

5. Dispositif électronique selon la revendication 4, où la zone de logement (230-2) de l'écran enroulable (230) est sensiblement plate dans la première direction (①) et la deuxième direction (②).

6. Dispositif électronique selon la revendication 5, où la zone de logement (230-2) de l'écran enroulable (230) est disposée de manière à ne pas faire face au couvercle arrière (700), de sorte que la zone de logement (230-2) soit davantage espacée de la zone d'écran (230-1) d'une distance correspondant à la différence entre la deuxième distance (L2) et la première distance (L1) et que le rayon de courbure de la zone de flexion (230-3) soit augmenté.

7. Dispositif électronique selon la revendication 1, où la zone de logement (230-2) de l'écran enroulable (230) est disposée entre la batterie (900) et le premier boîtier (210).

8. Dispositif électronique selon la revendication 1, comprenant en outre un élément de support (240) configuré pour supporter la zone de flexion (230-3) de l'écran enroulable (230), et un rail de guidage (226) configuré pour guider le mouvement de l'élément de support (240) en fonction du coulissement du deuxième boîtier (220), où l'élément de support (240) comprend une pluralité de parties de support en forme de barres segmentées les unes par rapport aux autres, et où les deux extrémités des parties de support sont insérées dans le rail de guidage (226).

9. Dispositif électronique selon la revendication 1, comprenant en outre un élément de verre protecteur (213) couplé au couvercle arrière (700),
où l'élément de verre protecteur (213) est formé de manière à ne pas faire face à l'écran enroulable (230) qui a coulissé dans le dispositif électronique lorsque le deuxième boîtier (220) est dans un état de coulissement vers l'intérieur complet dans la première direction (①).

10. Dispositif électronique selon la revendication 1, où
le couvercle arrière (700) recouvre la carte de circuit imprimé (251) et est configuré pour être recouvert par le premier boîtier (210) ou exposé à l'extérieur du dispositif électronique en fonction du coulissement du deuxième boîtier (220) par rapport au premier boîtier (210) ; et
comprenant en outre une partie mobile comprenant le moteur d'entraînement (260), et
où un espace d'expansion (A) est prévu entre le couvercle arrière (700) et l'écran enroulable (230), et où au moins une partie du moteur d'entraînement (260) de la partie mobile est configurée pour occuper l'espace d'expansion (A).

11. Dispositif électronique selon la revendication 10, où la partie mobile comprend un engrenage à pignons (261) relié au moteur d'entraînement (260) et un engrenage à crémaillère (2221) formé pour s'étendre dans la première direction (①) et la deuxième direction (②) et engrené avec l'engrenage à pignons (261).

12. Dispositif électronique selon la revendication 10, où une première distance (L1) correspondant à une distance entre la zone d'écran (230-1) de l'écran enroulable (230) et le couvercle arrière (700) dans une troisième direction (Z) perpendiculaire à la première direction (①) et à la deuxième direction (②) est inférieure à une deuxième distance (L2) correspondant à une distance entre la zone d'écran (230-1) de l'écran enroulable (230) et une surface du premier boîtier (210) dans la troisième direction (Z).

13. Dispositif électronique selon la revendication 12, où la zone de logement (230-2) de l'écran enroulable (230) est disposée de manière à ne pas faire face au couvercle arrière (700), de sorte que la zone de logement (230-2) soit davantage espacée de la zone d'écran (230-1) d'une distance correspondant à la différence entre la deuxième distance (L2) et la première distance (L1) et que le rayon de courbure de la zone de flexion (230-3) soit augmenté.

14. Dispositif électronique selon la revendication 10, comprenant en outre une batterie (900) disposée dans un espace prévu entre le premier boîtier (210) et le deuxième boîtier (220),
où la zone de logement (230-2) de l'écran enroulable (230) est disposée entre la batterie (900) et le premier boîtier (210).

15. Dispositif électronique selon la revendication 10, comprenant en outre un élément de support (240) configuré pour supporter l'écran enroulable (230) de manière à ce qu'il soit pliable, et un rail de guidage (226) configuré pour guider le mouvement de l'élément de support (240) en fonction du coulissement du premier boîtier (210), où l'élément de support (240) comprend une pluralité de parties de support en forme de barres segmentées les unes par rapport aux autres, et où les deux extrémités des parties de support sont insérées dans le rail de guidage (226).
